# EUROPEAN PATENT APPLICATION

(11) **EP 2 762 483 A1**
(43) Date of publication of application: **06.08.2014**
(21) Application number: 12831426.7
(22) Date of filing: 31.08.2012
(51) Int. Cl.: C07F 7/21, C09K 11/06, H01L 51/50

(54) **ORGANIC ELECTROLUMINESCENT ELEMENT MATERIAL HAVING SILICON-CONTAINING FOUR MEMBERED RING STRUCTURE, AND ORGANIC ELECTROLUMINESCENT ELEMENT**

(30) Priority: 12.09.2011 JP 2011198703
(71) Applicant: Nippon Steel & Sumikin Chemical Co., Ltd., Chiyoda-ku Tokyo 101-0021 (JP)
(72) Inventor: SUDA Mitsuru, Kitakyushu-shi Fukuoka 804-8503 (JP)
(74) Representative: Vossius & Partner
(86) International application number: PCT/JP2012/072272
(87) International publication number: WO 2013/038929

(57) **Abstract**

Provided are a material for an organic electroluminescent element formed of a silicon-containing four-membered ring compound, and an organic electroluminescent element using the material. The material for an organic electroluminescent element is formed of a compound represented by the following formula (1) and is used for, for example,a light-emitting layer containing a phosphorescent light-emitting dopant in an organic electroluminescent element. In the formula, X represents nitrogen or phosphorus, L's each represent an (n+1)-valent aromatic hydrocarbon group or aromatic heterocyclic group, and at least one of the L's represents an aromatic heterocyclic group. A₁ to A₆ each represent an alkyl group, a cycloalkyl group, an alkenyl group, an alkynyl group, an aromatic hydrocarbon group, an aromatic heterocyclic group, or an amino group, and n represents an integer of 0 to 3.

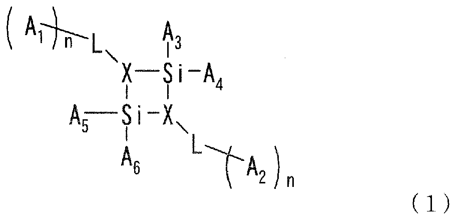

## Description

### Technical Field

The present invention relates to a material for an organic electroluminescent device having a silicon-containing four-membered ring structure and an organic electroluminescent device using the material, and more particularly, to a thin-film-type device that emits light when an electric field is applied to a light-emitting layer formed of an organic compound.

### Background Art

In general, an organic electroluminescent device (hereinafter referred to as organic EL device) includes a light-emitting layer and a pair of counter electrodes interposing the light-emitting layer therebetween in its simplest structure. That is, the organic EL device uses the phenomenon that, when an electric field is applied between both the electrodes, electrons are injected from a cathode and holes are injected from an anode, and each electron and each hole recombine in the light-emitting layer to emit light.

In recent years, progress has been made in developing an organic EL device using an organic thin film. In order to enhance luminous efficiency particularly, optimization of kinds of electrodes has been attempted for the purpose of improving efficiency of injection of carriers from the electrodes. As a result, there has been developed a device in which a hole-transporting layer formed of an aromatic diamine and a light-emitting layer formed of an 8-hydroxyquinoline aluminum complex (hereinafter referred to as Alq3) are formed between electrodes as thin films, resulting in a significant improvement in luminous efficiency, as compared to conventional devices in which a single crystal of anthracene molecules or the like is used. Thus, development of the above-mentioned organic EL device has been promoted in order to accomplish its practical application to a high-performance flat panel having features such as self-luminescence and rapid response.

Further, studies have been made on using phosphorescent light rather than fluorescent light as an attempt to raise luminous efficiency of a device. Many kinds of devices including the above-mentioned device in which a hole-transporting layer formed of an aromatic diamine and a light-emitting layer formed of Alq3 are formed emit light by using fluorescent light emission. However, by using phosphorescent light emission, that is, by using light emission from a triplet excited state, luminous efficiency is expected to be improved by about three times to four times, as compared to the case of using conventional devices in which fluorescent light (singlet) is used. In order to accomplish this purpose, studies have been made on adopting a coumarin derivative or a benzophenone derivative as a light-emitting layer, but extremely low luminance has only been provided. Further, studies have been made on using a europium complex as an attempt to use a triplet state, but highly efficient light emission has not been accomplished. In recent years, many studies centered on an organic metal complex such as an iridium complex have been made, as disclosed in Patent Literature 1, for the purpose of attaining high luminous efficiency and a long lifetime.

Not only the dopant material but also a host material to be used is important for obtaining high luminous efficiency. A typical material that has been proposed as the host material is, for example, 4,4'-bis(9-carbazolyl)biphenyl (hereinafter referred to as "CBP") as a carbazole compound introduced in Patent Literature 2. CBP shows a relatively good light-emitting characteristic when used as a host material for a green phosphorescent light-emitting material typified by a tris(2-phenylpyridine)iridium complex (hereinafter referred to as "Ir(ppy)3"). On the other hand, CBP does not provide sufficient luminous efficiency when used as a host material for a blue phosphorescent light-emitting material. This results from the fact that an energy level of the lowest excited triplet state of CBP is lower than that of a general blue phosphorescent light-emitting material and hence a triplet excitation energy of the blue phosphorescent light-emitting material transfers to CBP. In other words, the phosphorescent host material has a higher triplet excitation energy than that of the phosphorescent light-emitting material to trap the triplet excitation energy of the phosphorescent light-emitting material effectively, whereby high luminous efficiency is achieved. In Non Patent Literature 1, the triplet excitation energy is improved through modification of a structure of CBP for the purpose of improving the energy-trapping effect, whereby luminous efficiency of a bis[2-(4,6-difluorophenyl)pyridinato-N,C2'](picolinato)iridium complex (hereinafter referred to as "FIrpic") is improved. In addition, in Non Patent Literature 2, the luminous efficiency is improved through the same effect by using 1,3-dicarbazolylbenzene (hereinafter referred to as "mCP") as a host material. However, none of those materials is satisfactory in practical use particularly from the viewpoint of durability.

In addition, balanced injecting/transporting characteristics for both charges (a hole and an electron) are needed for obtaining high luminous efficiency. An electron-transporting ability of CBP is inferior to its hole-transporting ability. Accordingly, a charge balance in the light-emitting layer is broken and excessive holes flow out to a cathode side, thereby causing a reduction in luminous efficiency due to a reduction in recombination probability in the light-emitting layer. Further, in this case, a recombination region of the light-emitting layer is limited to a narrow region near an interface on the cathode side. Accordingly, when an electron-transporting material having a small energy level of the lowest excited triplet state with respect to Ir(ppy)3 such as Alq3 is used, a reduction in luminous efficiency due to transfer of a triplet excitation energy from a dopant to the electron-transporting material may also occur.

As described above, a host material having a high triplet excitation energy and balanced injecting/transporting characteristics for both charges (a hole and an electron) is needed for obtaining high luminous efficiency in an organic EL device. Further desired is a compound having electrochemical stability, high heat resistance, and excellent amorphous stability, and hence further improvement has been demanded.

In addition, as an organic EL device using a compound related to the present invention, Patent Literature 3 discloses an organic EL device using, as a material for a hole-transporting layer, a silicon-containing four-membered ring compound substituted with an aryl group as shown below, but does not disclose a silicon-containing four-membered ring compound substituted with an aromatic heterocyclic group and its usefulness.

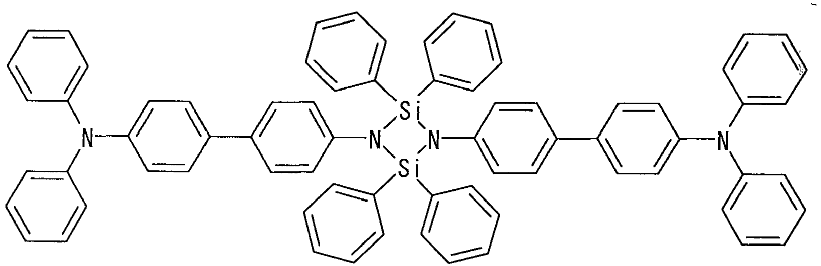

Patent Literature 4 discloses a silicon-containing four-membered ring compound substituted with an aryl group, but does not teach use of the compound as a material for an organic EL device.

### Citation List

### Patent Literature

[PTL 1] JP 2003-515897 A
[PTL 2] JP 2001-313178 A
[PTL 3] WO 1990/14744 A1
[PTL 4] US 3140288 A

### Non Patent Literature

[NPL 1] Applied Physics Letters, 2003, 83, 569-571.
[NPL 2] Applied Physics Letters, 2003, 82, 2422-2424.

### Summary of Invention

In order to apply an organic EL device to a display device in a flat panel display or the like, it is necessary to improve the luminous efficiency of the device and also to ensure sufficiently the stability in driving the device. The present invention has an object to provide, in view of the above-mentioned circumstances, an organic EL device, which has high efficiency, has high driving stability, and is practically useful and a compound suitable for the organic EL device.

The inventors of the present invention have made intensive studies and have consequently found that, when a novel aromatic heterocycle-substitutedsilicon-containingfour-membered ring compound is used as a material for an organic electroluminescent device in an organic electroluminescent device, the organic electroluminescent device exhibits excellent characteristics such as high efficiency and a long life time. As a result, the present invention has been completed.

The present invention relates to a material for an organic electroluminescent device, including a silicon-containing four-membered ring compound represented by the general formula (1) : 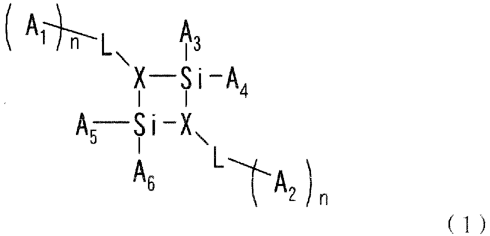 in the formula (1) : X's each independently represent nitrogen or phosphorus; L's each independently represent an (n+1) -valent aromatic hydrocarbon group having 6 to 24 carbon atoms or an (n+1) -valent aromatic heterocyclic group having 3 to 19 carbon atoms, and at least one of the L's represents an aromatic heterocyclic group having 3 to 9 carbon atoms ; A₁ to A₆ each independently represent an alkyl group having 1 to 30 carbon atoms, a cycloalkyl group having 3 to 3 0 carbon atoms, an alkenyl group having 2 to 30 carbon atoms, an alkynyl group having 2 to 30 carbon atoms, an aromatic hydrocarbon group having 6 to 50 carbon atoms, an aromatic heterocyclic group having 3 to 50 carbon atoms, or an amino group having 2 to 30 carbon atoms; and n's each independently represent an integer of 0 to 3.

The present invention also relates to a material for an organic electroluminescent device formed of a compound in which the two X's in the general formula (1) each represent nitrogen or each represent phosphorus. The material is preferably formed of a compound in the two X's each represent nitrogen.

The present invention also relates to a material for an organic electroluminescent device formed of a compound in which the two L' s in the general formula (1) each represent an (n+1) -valent aromatic heterocyclic group having 3 to 19 carbon atoms. The two L's preferably represent the same aromatic heterocyclic group.

The present invention also relates to an organic electroluminescent device, including: a substrate; an anode; at least one organic layer; and a cathode, the anode, the organic layer, and the cathode being laminated on the substrate, in which the organic layer contains the material for an organic electroluminescent device formed of the compound represented by the general formula (1).

The present invention also relates to an organic electroluminescent device, in which the organic layer containing the compound represented by the general formula (1) includes at least one layer selected from the group consisting of a light-emitting layer, an electron-transporting layer, a hole-transporting layer, an electron-blocking layer, and a hole-blocking layer. In addition, in the organic electroluminescent device, the organic layer containing the compound represented by the general formula (1) desirably includes a light-emitting layer containing a phosphorescent light-emitting dopant.

### Brief Description of Drawings

FIG. 1 is a schematic sectional view illustrating a structural example of an organic EL device.
FIG. 2 shows a ¹H-NMR chart of a compound 1-4.
FIG. 3 shows a ¹H-NMR chart of a compound 3-3.

### Description of Embodiments

A material for an organic electroluminescent device of the present invention is a silicon-containing four-membered ring compound represented by the general formula (1). In the general formula (1), X's each independently represent nitrogen or phosphorus. It is preferred that the two X's each represent nitrogen or each represent phosphorus, and it is more preferred that the X's each represent nitrogen.

In the general formula (1), L's each independently represent an (n+1) -valent aromatic hydrocarbon group having 6 to 24 carbon atoms or an (n+1) -valent aromatic heterocyclic group having 3 to 19 carbon atoms, and at least one of the L's represents an aromatic heterocyclic group having 3 to 19 carbon atoms. It is preferred that the X's each represent an (n+1)-valent aromatic heterocyclic group having 3 to 19 carbon atoms, and it is more preferred that the two L's represent the same aromatic heterocyclic group.

Specific examples of the aromatic hydrocarbon group include (n+1) -valent groups produced by removing n+1 hydrogen atoms from, for example, benzene, pentalene, indene, naphthalene, azulene, heptalene, octalene, indacene, acenaphthylene, fluorene, phenalene, phenanthrene, anthracene, trindene, fluoranthene, acephenanthrylene, aceanthrylene, triphenylene, pyrene, chrysene, tetraphene, tetracene, pleiadene, picene, perylene, pentaphene, pentacene, tetraphenylene, cholanthrene, or coronene. Preferred examples thereof include (n+1)-valent groups obtained by removing n+1 hydrogen atoms from benzene, indene, naphthalene, acenaphthylene, fluorene, phenanthrene, anthracene, fluoranthene, triphenylene, pyrene, chrysene, tetracene, perylene, pentacene, ortetraphenylene. More preferred examples thereof include (n+1) -valent groups produced by removing n+1 hydrogen atoms from benzene, naphthalene, fluorene, phenanthrene, anthracene, fluoranthene, triphenylene, or pyrene.

Specific examples of the aromatic heterocyclic group include (n+1) -valent groups produced by removing n+1 hydrogen atoms from, for example, furan, benzofuran, isobenzofuran, xanthene, oxanthrene, dibenzofuran, peri-xanthenoxanthene, thiophene, thioxanthene, thianthrene, phenoxathiin, thionaphthene, isothianaphthene, thiophthene, thiophanthrene, dibenzothiophene, pyrrole, pyrazole, tellurazole, selenazole, thiazole, isothiazole, oxazole, furazan, pyridine, pyrazine, pyrimidine, pyridazine, triazine, indolizine, indole, isoindole, indazole, purine, quinolizine, isoquinoline, carbazole, imidazole, naphthyridine, phthalazine, quinazoline, benzodiazepine, quinoxaline, cinnoline, quinoline, pteridine, phenanthridine, acridine, perimidine, phenanthroline, phenazine, carboline, phenotellurazine, phenoselenazine, phenothiazine, phenoxazine, anthyridine, benzothiazole, benzimidazole, benzoxazole, benzisooxazole, benzisothiazole, indoloindole, or indolocarbazole. Preferred examples thereof include (n+1)-valent groups produced by removing n+1 hydrogen atoms from benzene, indene, naphthalene, acenaphthylene, fluorene, phenanthrene, anthracene, fluoranthene, triphenylene, pyrene, chrysene, tetracene, perylene, pentacene, tetraphenylene, furan, benzofuran, dibenzofuran, thiophene, thianthrene, dibenzothiophene, pyrrole, pyrazole, thiazole, pyridine, pyrazine, pyrimidine, pyridazine, triazine, indolizine, indole, isoindole, indazole, quinolizine, isoquinoline, carbazole, imidazole, naphthyridine, quinazoline, quinoxaline, quinoline, acridine, perimidine, phenanthroline, phenazine, carboline, phenotellurazine, phenoselenazine, phenothiazine, phenoxazine, benzothiazole, benzimidazole, or benzoxazole. More preferred examples thereof include (n+1) -valent groups produced by removing n+1 hydrogen atoms from benzene, naphthalene, fluorene, phenanthrene, anthracene, fluoranthene, triphenylene, pyrene, furan, benzofuran, dibenzofuran, thiophene, thianthrene, dibenzothiophene, pyridine, pyrimidine, triazine, indole, carbazole, quinoline, or phenanthroline.

L'seach represent an (n+1) -valent aromatic hydrocarbon group or aromatic heterocyclic group. It is understood that A₁ or A₂ serves as a substituent and hence L's each represent a group free of any other substituent.

In the general formula (1), A₁ to A₆ each independently represent an alkyl group having 1 to 30 carbon atoms, a cycloalkyl group having 3 to 30 carbon atoms, an alkenyl group having 2 to 30 carbon atoms, an alkynyl group having 2 to 30 carbon atoms, an aromatic hydrocarbon group having 6 to 50 carbon atoms, an aromatic heterocyclic group having 3 to 50 carbon atoms, or an amino group having 2 to 30 carbon atoms.

In A₁ to A₆ in the general formula (1), specific examples of the alkyl group include a methyl group, an ethyl group, a propyl group, a butyl group, a pentyl group, a hexyl group, a heptyl group, an octyl group, a nonyl group, and a decyl group. Preferred examples thereof include a methyl group, an ethyl group, a propyl group, a butyl group, a pentyl group, a hexyl group, a heptyl group, and an octyl group. The alkyl group may be linear or branched.

The alkyl group may have a substituent, and when the group has a substituent, the substituent is a cycloalkyl group having 3 to 11 carbon atoms, an aromatic hydrocarbon group having 6 to 18 carbon atoms, or an aromatic heterocyclic group having 3 to 18 carbon atoms.

When the alkyl group has a substituent, the total number of substituents is 1 to 6. The number is preferably 1 to 4, more preferably 1 or 2. In addition, when the group has two or more substituents, the substituents may be identical to or different from each other.

In the description, in the calculation of the number of carbon atoms, when the group has a substituent, the number of carbon atoms of the substituent is also included. The number of carbon atoms in the alkyl group is 1 to 30, preferably 1 to 14.

In A₁ to A₆, specific examples of the cycloalkyl group include a cyclopropyl group, a cyclobutyl group, a cyclopentyl group, a cyclohexyl group, a cycloheptyl group, a cyclooctyl group, a cyclohexyl group, and a decahydronaphthyl group. Preferred examples thereof include a cyclohexyl group and a cyclohexyl group.

The cycloalkyl group may have a substituent, and when the group has a substituent, the substituent is an alkyl group having 1 to 10 carbon atoms, an aromatic hydrocarbon group having 6 to 18 carbon atoms, or an aromatic heterocyclic group having 3 to 18 carbon atoms.

When the cycloalkyl group has a substituent, the total number of substituents is 1 to 6. The number is preferably 1 to 4, more preferably 1 or 2. In addition, when the group has two or more substituents, the substituents may be identical to or different from each other. The number of carbon atoms in the cycloalkyl group is 3 to 30, preferably 4 to 14.

In A₁ to A₆, specific examples of the alkenyl group or the alkynyl group include an ethylenyl group, a propylenyl group, a butenyl group, a pentenyl group, a hexenyl group, a heptenyl group, an octenyl group, an acetylenyl group, a propynyl group, a butynyl group, and a pentynyl group. Preferred examples thereof include an ethylenyl group, a propylenyl group, a butenyl group, an acetylenyl group, and a propynyl group. The alkenyl group and the alkynyl group may be linear or branched.

The alkenyl group or the alkynyl group may have a substituent, and when any such group has a substituent, the substituent is a cycloalkyl group having 3 to 11 carbon atoms, an aromatic hydrocarbon group having 6 to 18 carbon atoms, or an aromatic heterocyclic group having 3 to 18 carbon atoms. The number of carbon atoms in the alkenyl group or the alkynyl group is 2 to 30, preferably 2 to 14.

In A₁ to A₆, specific examples of the aromatic hydrocarbon group or the aromatic heterocyclic group include a monovalent group produced by removing hydrogen from benzene, pentalene, indene, naphthalene, azulene, heptalene, octalene, indacene, acenaphthylene, phenalene, phenanthrene, anthracene, trindene, fluoranthene, acephenanthrylene, aceanthrylene, triphenylene, pyrene, chrysene, tetraphene, tetracene, pleiadene, picene, perylene, pentaphene, pentacene, tetraphenylene, cholanthrylene, helicene, hexaphene, rubicene, coronene, trinaphthylene, heptaphene, pyranthrene, furan, benzofuran, isobenzofuran, xanthene, oxathrene, dibenzofuran, peri-xanthenoxanthene, thiophene, thioxanthene, thianthrene, phenoxathiin, thionaphthene, isothianaphthene, thiophthene, thiophanthrene, dibenzothiophene, pyrrole, pyrazole, tellurazole, selenazole, thiazole, isothiazole, oxazole, furazan, pyridine, pyrazine, pyrimidine, pyridazine, triazine, indolizine, indole, isoindole, indazole, purine, quinolizine, isoquinoline, carbazole, imidazole, naphthyridine, phthalazine, quinazoline, benzodiazepine, quinoxaline, cinnoline, quinoline, pteridine, phenanthridine, acridine, perimidine, phenanthroline, phenazine, carboline, phenotellurazine, phenoselenazine, phenothiazine, phenoxazine, anthyridine, benzothiazole, benzimidazole, benzoxazole, benzisoxazole, benzisothiazole, or an aromatic compound in which a plurality of such aromatic rings are linked to each other. Preferred examples thereof include a monovalent group produced by removing hydrogen from benzene, naphthalene, anthracene, pyridine, pyrazine, pyrimidine, pyridazine, triazine, isoindole, indazole, purine, isoquinoline, imidazole, naphthyridine, phthalazine, quinazoline, benzodiazepine, quinoxaline, cinnoline, quinoline, pteridine, phenanthridine, acridine, perimidine, phenanthroline, phenazine, carboline, indole, carbazole, or an aromatic compound in which a plurality of such aromatic rings are linked to each other.

It should be noted that in the case of the group produced from an aromatic compound in which a plurality of aromatic rings are linked to each other, the number of the aromatic rings to be linked to each other is preferably 2 to 6, more preferably 2 or 3, and the aromatic rings to be linked to each other may be identical to or different from each other. In that case, the bonding positions of A₁ to A₆ to be bonded to Si or L are not limited, and A₁ to A₆ may each be bonded to a ring at a terminal portion of linked aromatic rings or may each be bonded to a ring at the central portion thereof. Here, the term "aromatic ring" is a generic term for an aromatic hydrocarbon ring and an aromatic heterocycle. In addition, when the linked aromatic rings include at least one heterocycle, the linked aromatic rings are included in the category of the aromatic heterocyclic group.

Here, the monovalent group produced by the linking of a plurality of aromatic rings is, for example, represented by any one of the following formulae:

**-Ar₁-Ar₂-Ar₃** (11)

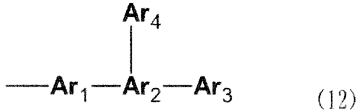

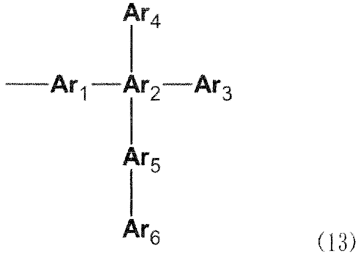

in the formulae (11) to (13), Ar₁ to Ar₆ each represent a substituted or non-substituted aromatic ring.

Specific examples of the group produced by linking a plurality of aromatic rings include monovalent groups each produced by removing hydrogen from, for example, biphenyl, terphenyl, bipyridine, bipyrimidine, bitriazine, terpyridine, bistriazylbenzene, dicarbazolylbenzene, carbazolylbiphenyl, dicarbazolylbiphenyl, phenylterphenyl, carbazolylterphenyl, binaphthalene, phenylpyridine, phenylcarbazole, diphenylcarbazole, diphenylpyridine, phenylpyrimidine, diphenylpyrimidine, phenyltriazine, diphenyltriazine, phenylnaphthalene, or diphenylnaphthalene.

The aromatic hydrocarbon group or the aromatic heterocyclic group may have a substituent, and when any such group has a substituent, the substituent is an alkyl group having 1 to 10 carbon atoms, a cycloalkyl group having 3 to 10 carbon atoms, an alkoxy group having 1 to 6 carbon atoms, an acetyl group, an amino group having 6 to 18 carbon atoms, a phosphanyl group having 6 to 18 carbon atoms, or a silyl group having 3 to 18 carbon atoms. The substituent is preferably an alkyl group having 1 to 4 carbon atoms, a cycloalkyl group having 3 to 6 carbon atoms, or an amino group having 6 to 15 carbon atoms. It should be noted that in this case, an aromatic group linked in a branched manner is not treated as a substituent.

When A₁ to A₆ each represent an aromatic hydrocarbon group or an aromatic heterocyclic group and the group has a substituent, the total number of substituents is 1 to 6. The number is preferably 1 to 4, more preferably 1 or 2. In addition, when the group has two or more substituents, the substituents may be identical to or different from each other.

In A₁ to A₆, the amino group is a monovalent group having 2 to 30 carbon atoms represented by the following formula (4).

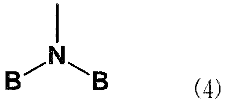

In the formula (4), B's each independently represent hydrogen, an alkyl group having 1 to 10 carbon atoms, a cycloalkyl group having 3 to 10 carbon atoms, an aromatic hydrocarbon group having 6 to 18 carbon atoms, or an aromatic heterocyclic group having 3 to 18 carbon atoms. The total number of carbon atoms in two B's is 2 to 30.

In the formula (4), specif ic examples of the alkyl group represented by each of B's include a methyl group, an ethyl group, a propyl group, a butyl group, a pentyl group, a hexyl group, a heptyl group, an octyl group, a nonyl group, and a decyl group. Of those, a methyl group, an ethyl group, a propyl group, a butyl group, a pentyl group, a hexyl group, a heptyl group, or an octyl group is preferred. The alkyl group may be linear or branched.

In the formula (4), specific examples of the cycloalkyl group represented by each of B's include a cyclopropyl group, a cyclobutyl group, a cyclopentyl group, a cyclohexyl group, a cycloheptyl group, a cyclooctyl group, and a methylcyclohexyl group. Of those, a cyclohexyl group or a methylcyclohexyl group is preferred.

In the formula (4), specific examples of the aromatic hydrocarbon group or aromatic heterocyclic group represented by each of B's include a phenyl group, a naphthyl group, a phenanthryl group, a pyridyl group, a pyrimidyl group, a triazyl group, a quinolyl group, and a carbazolyl group. Of those, a phenyl group, a naphthyl group, a pyridyl group, or a quinolyl group is preferred, and a phenyl group or a naphthyl group is more preferred.

When B's each represent an aromatic hydrocarbon group or an aromatic heterocyclic group, any such group may have a substituent. When the group has a substituent, examples of the substituent include an alkyl group having 1 to 4 carbon atoms, a cycloalkyl group having 3 to 6 carbon atoms, an alkoxy group having 1 or 2 carbon atoms, and an acetyl group.

In the general formula (1), n's each independently represent an integer of 0 to 3. It is preferred that n's each independently represent an integer of 0 to 2.

Hereinafter, specific examples of the compound represented by the general formula (1) are shown as exemplified compounds. The compound serving as the material for an organic EL device of the present invention is not limited to the exemplified compounds.

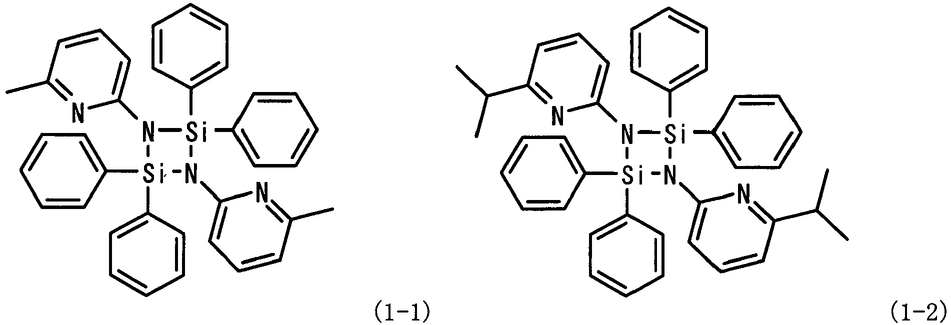

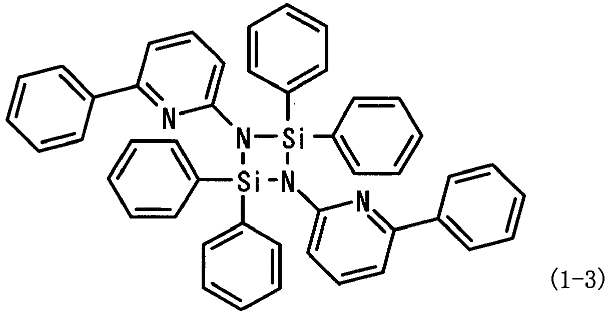

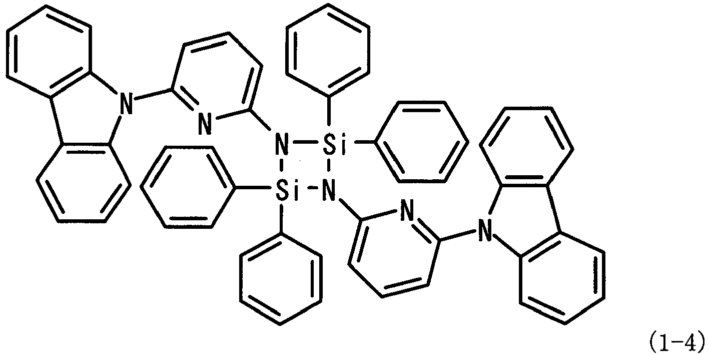

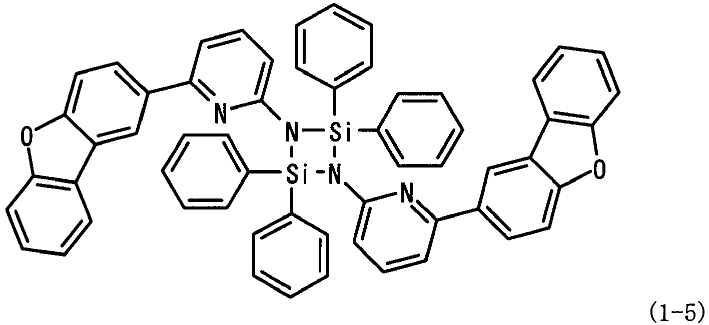

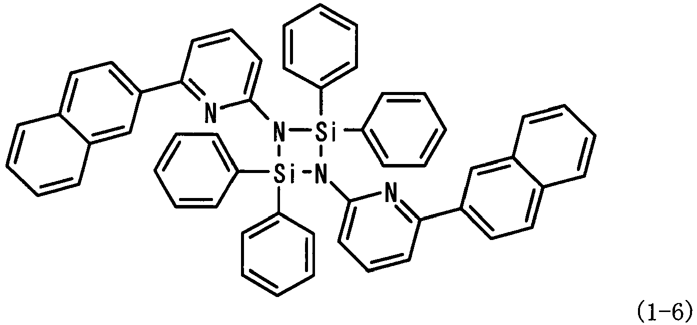

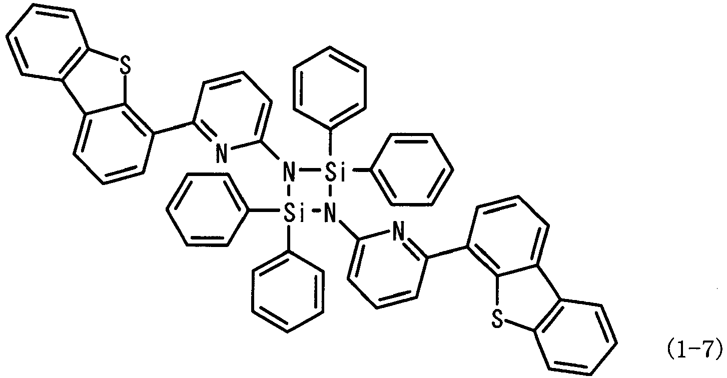

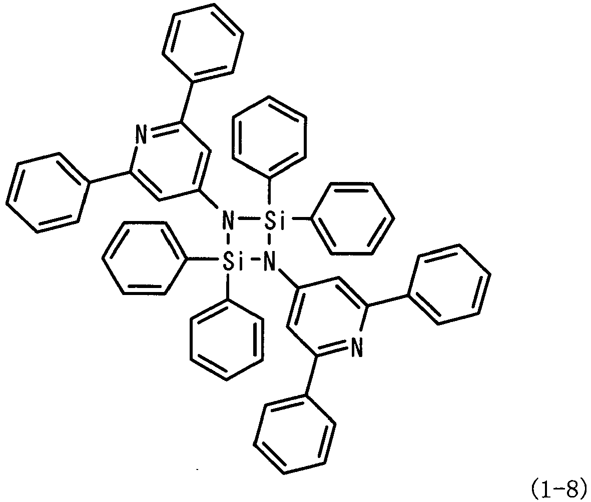

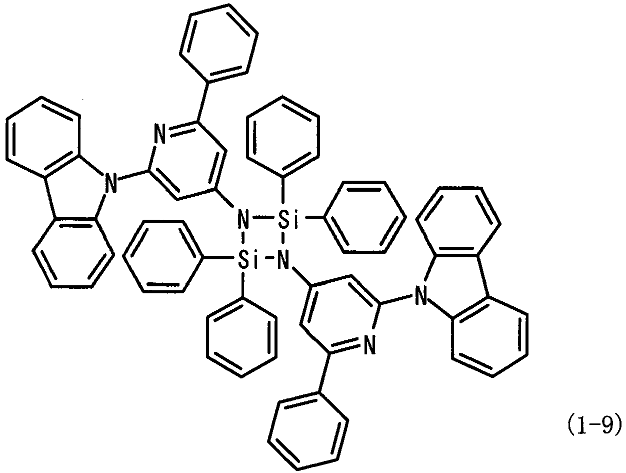

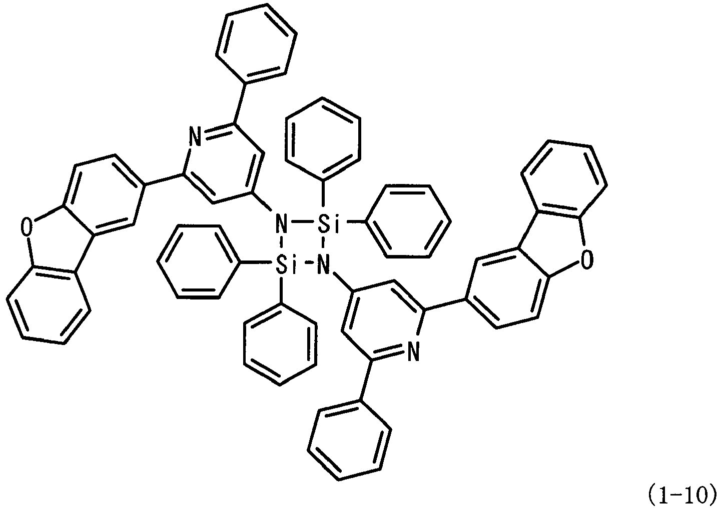

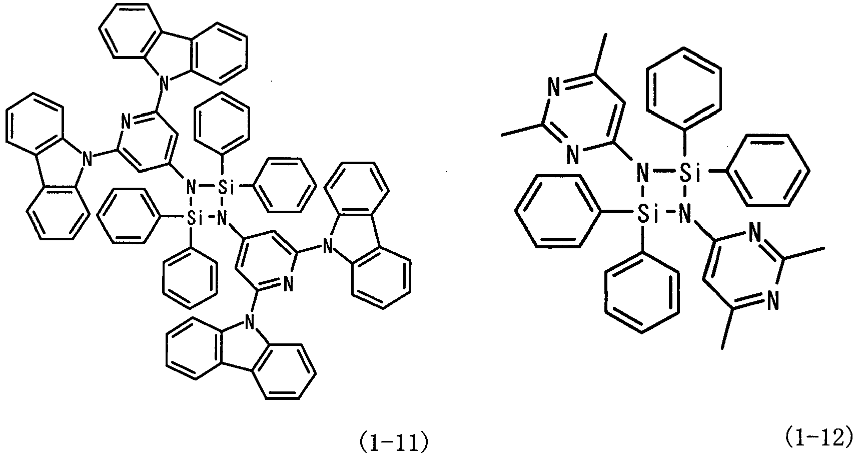

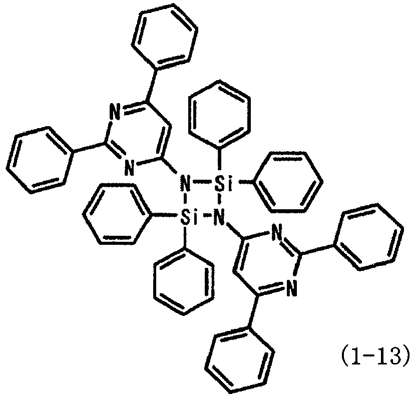

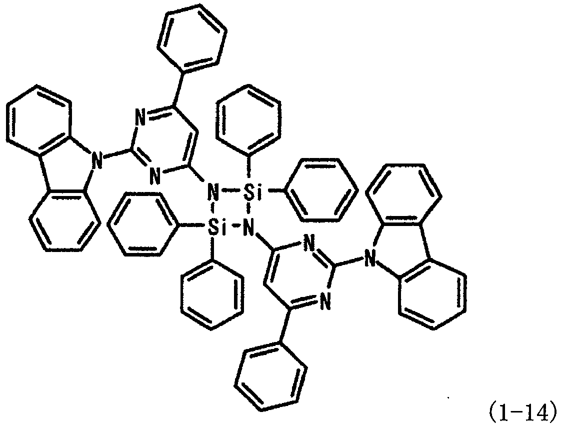

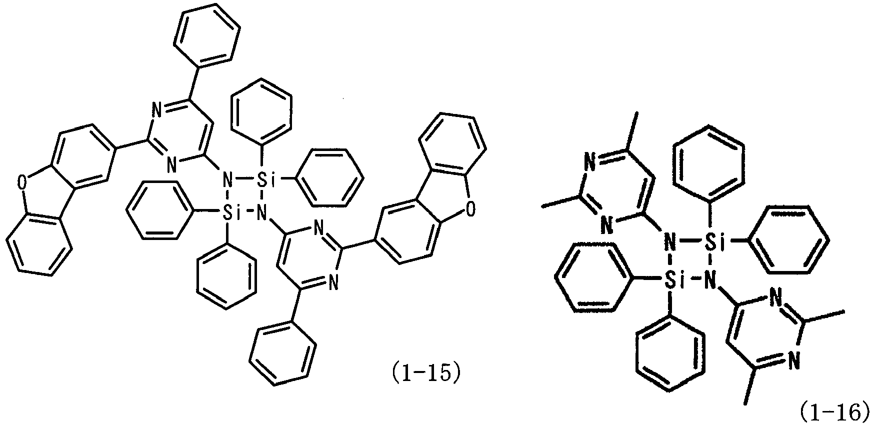

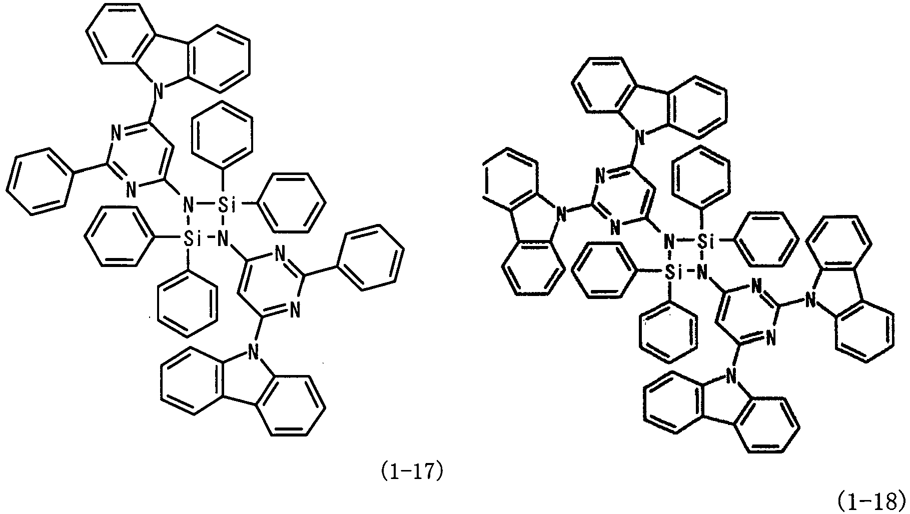

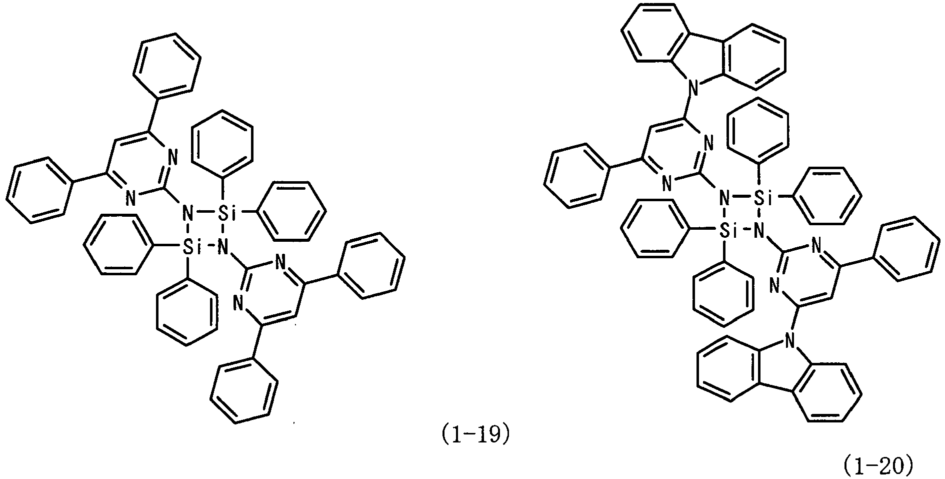

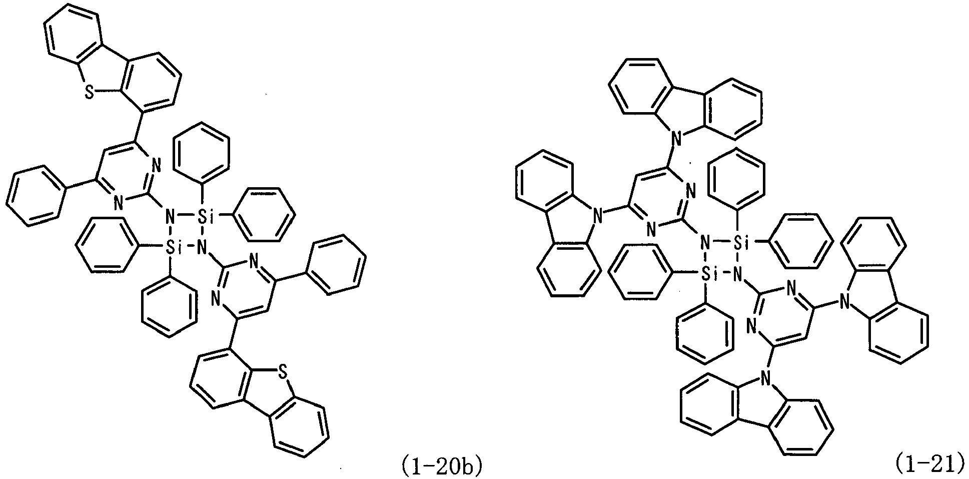

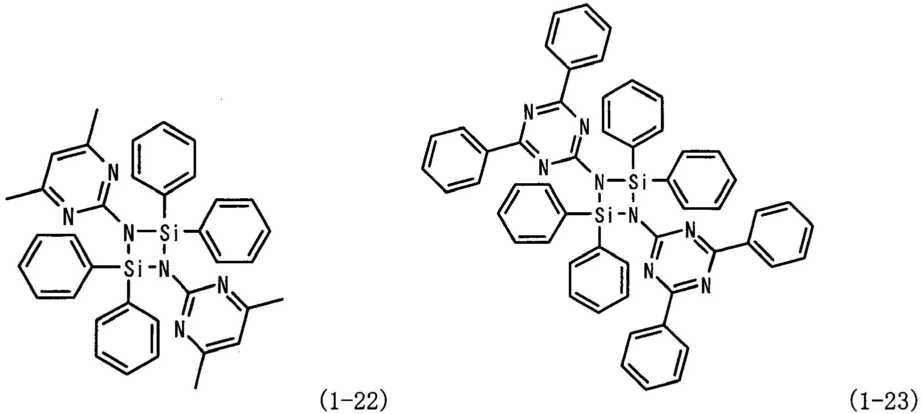

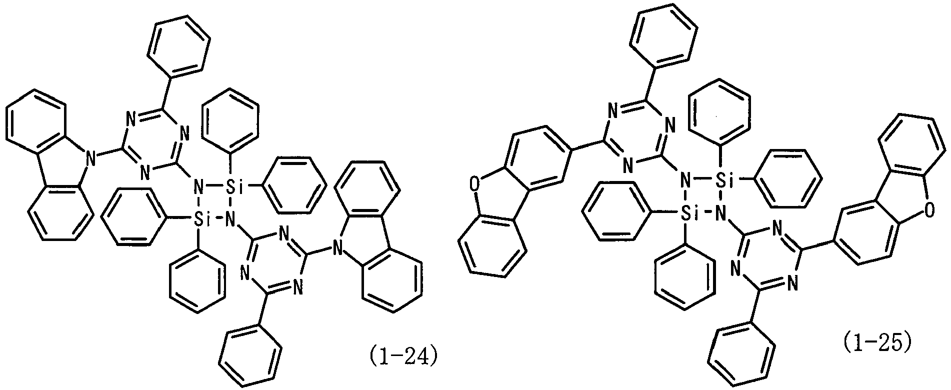

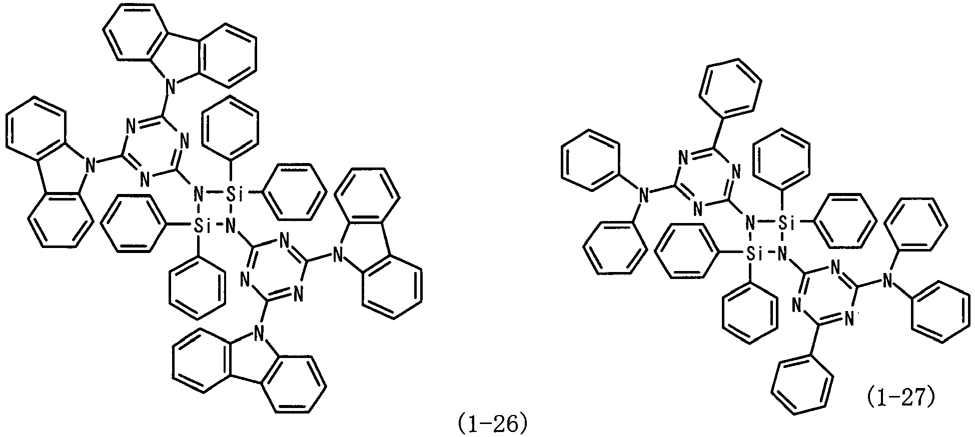

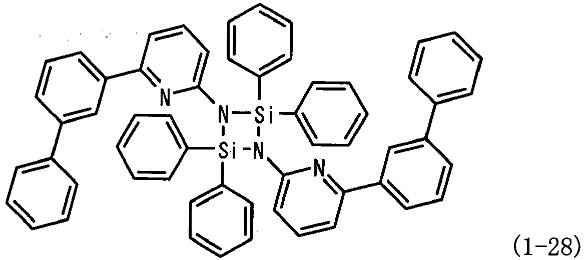

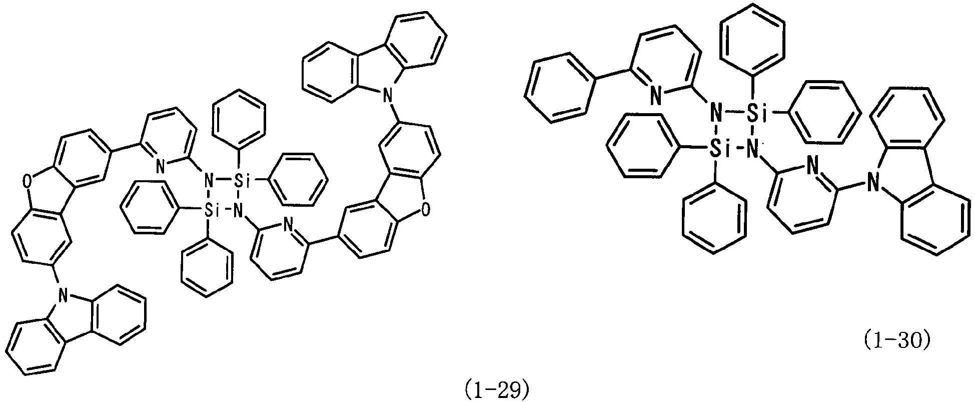

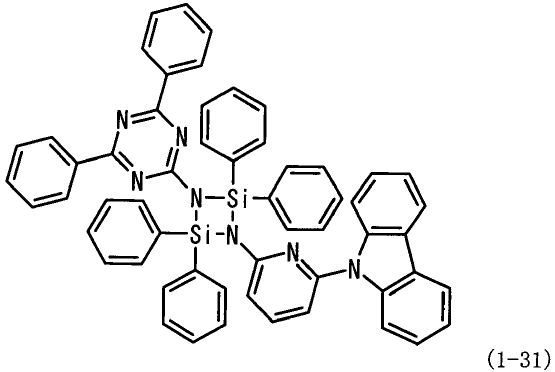

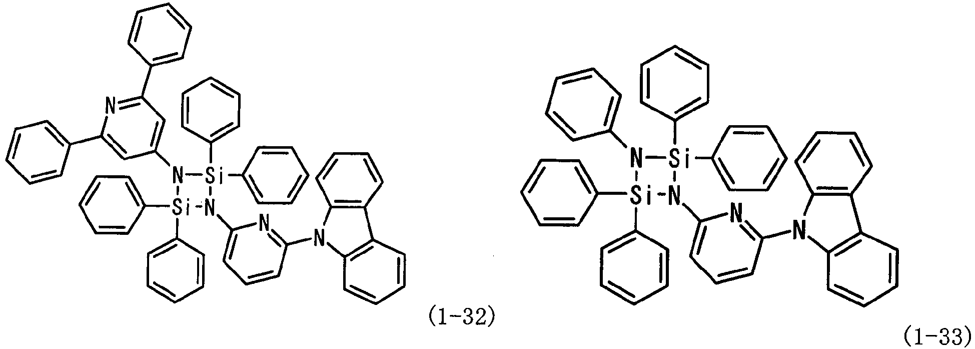

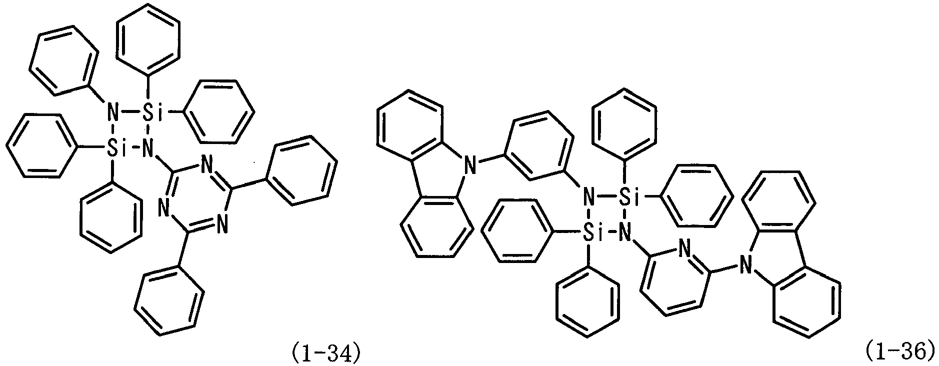

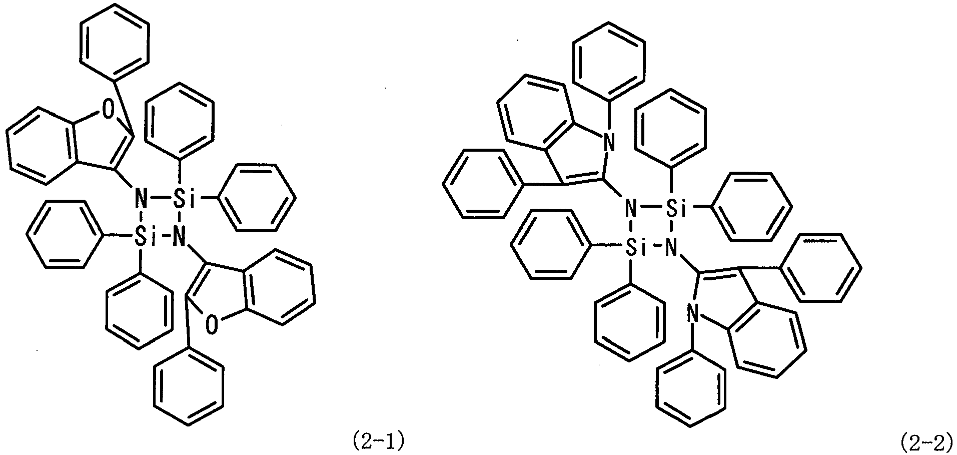

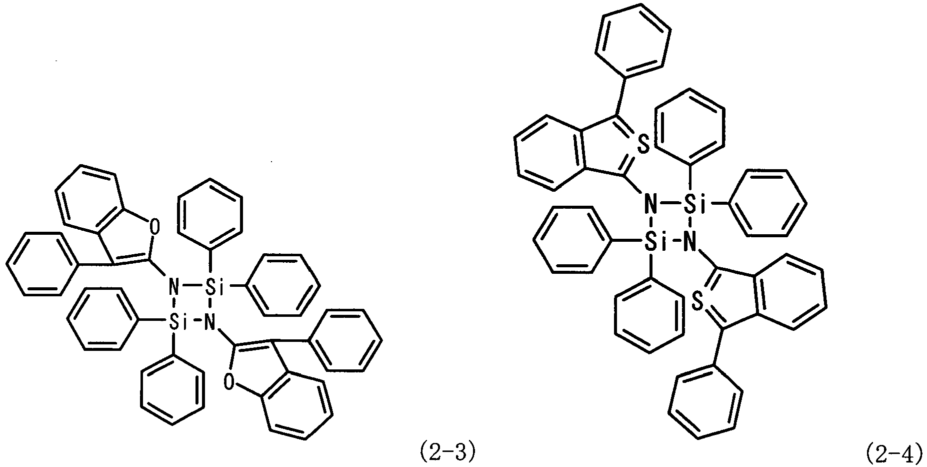

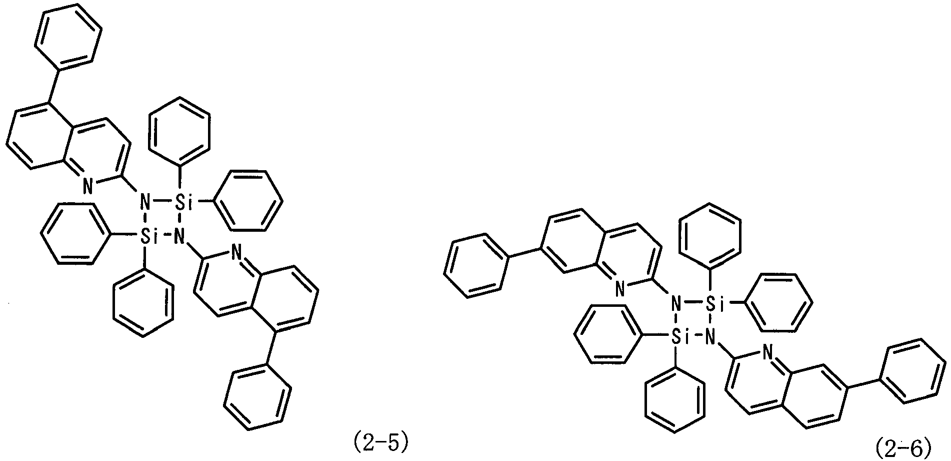

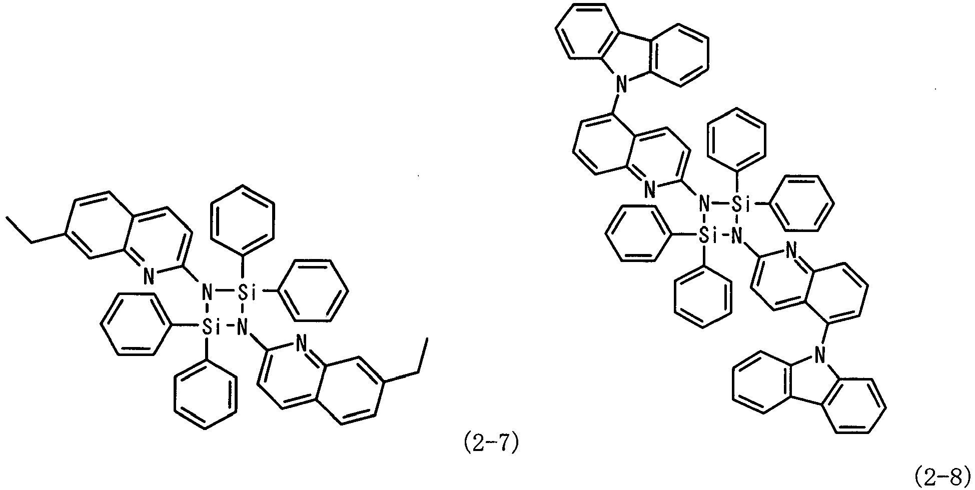

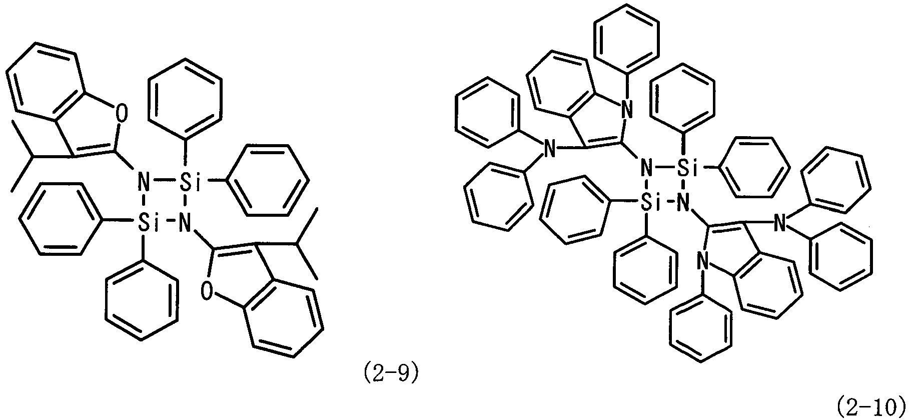

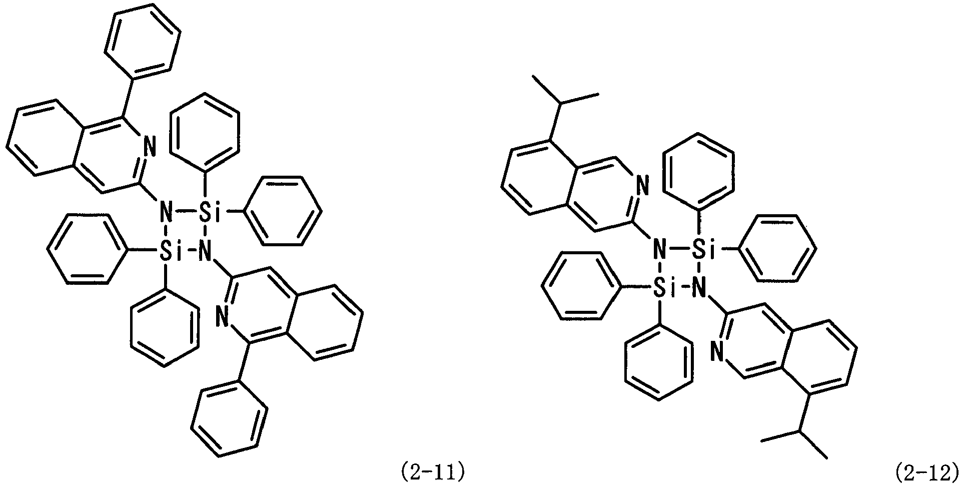

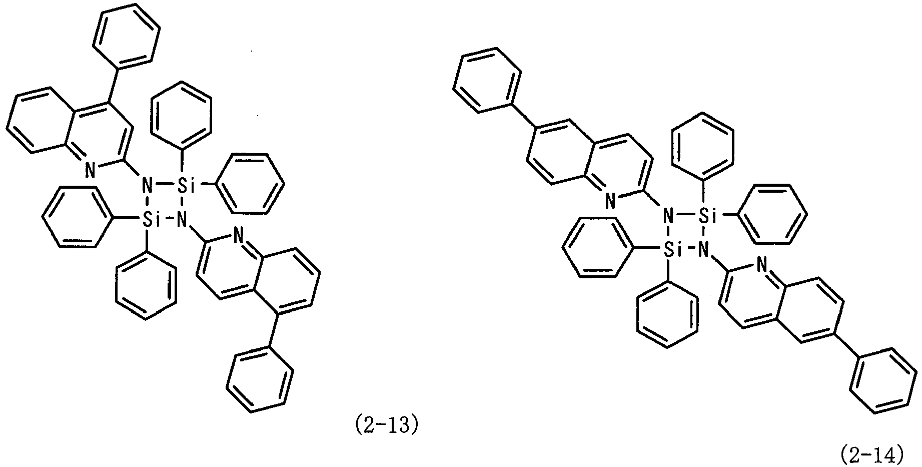

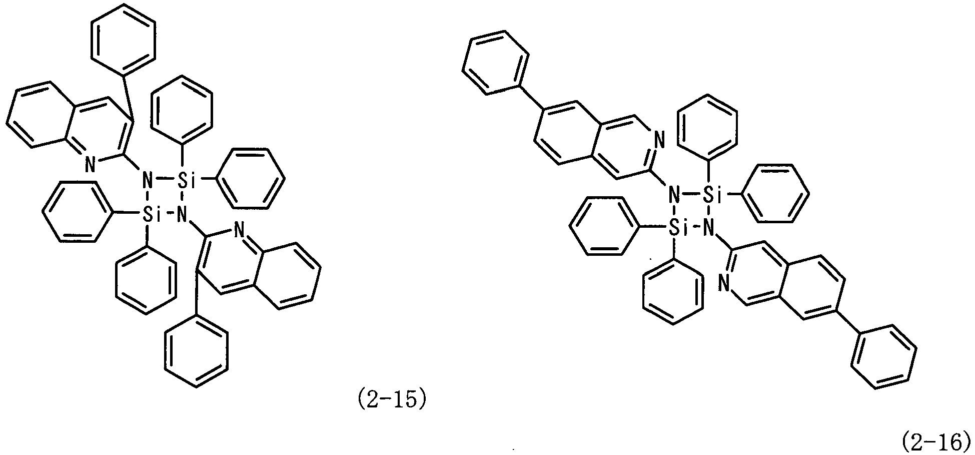

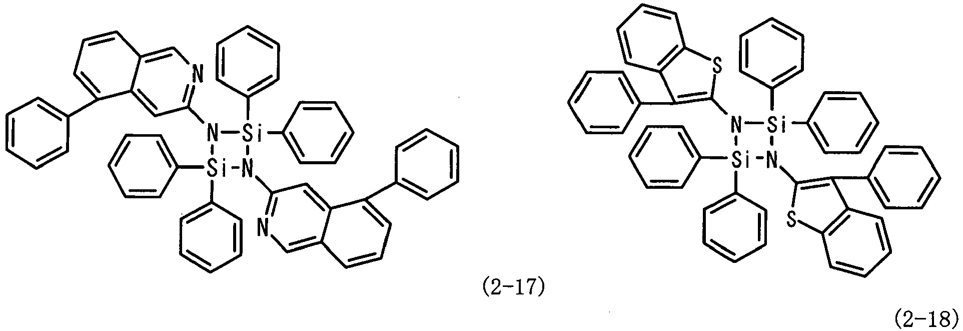

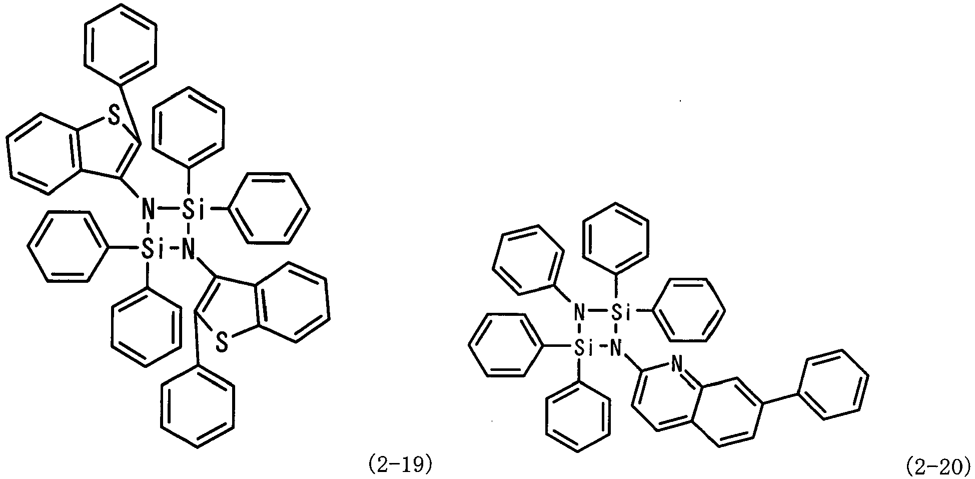

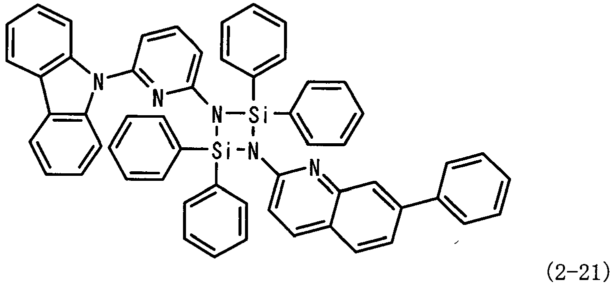

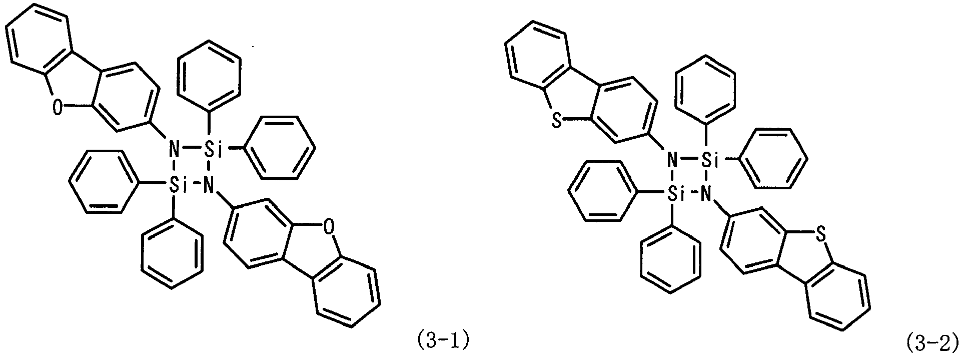

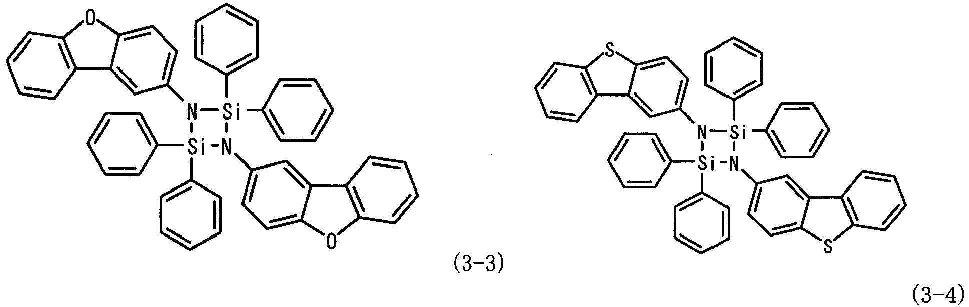

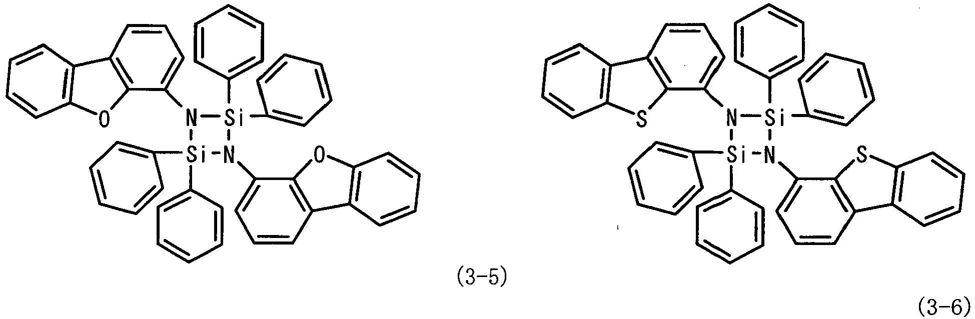

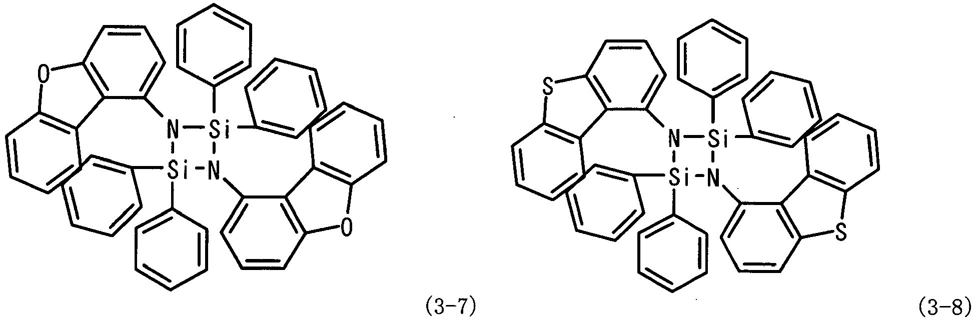

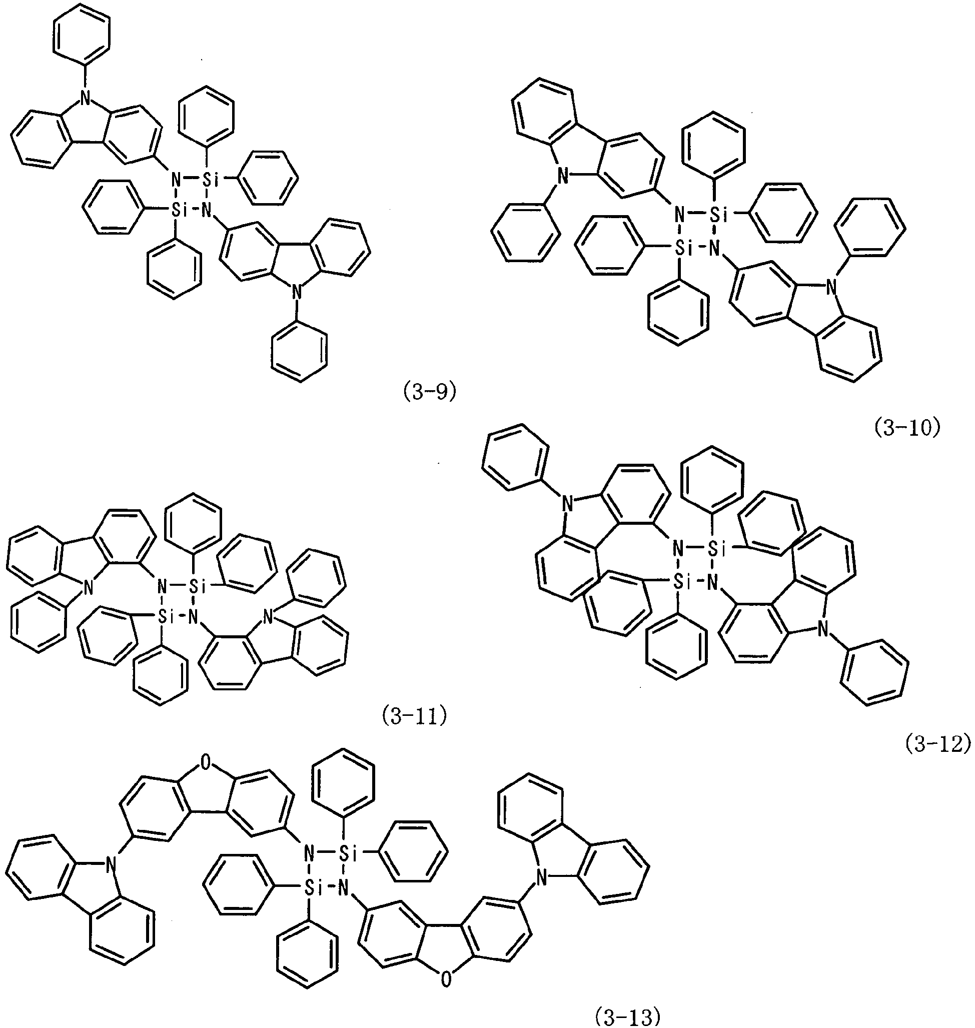

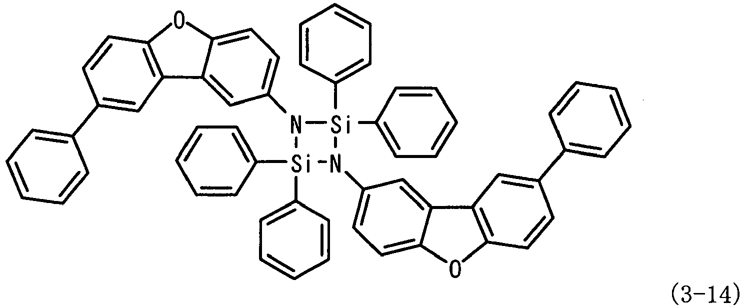

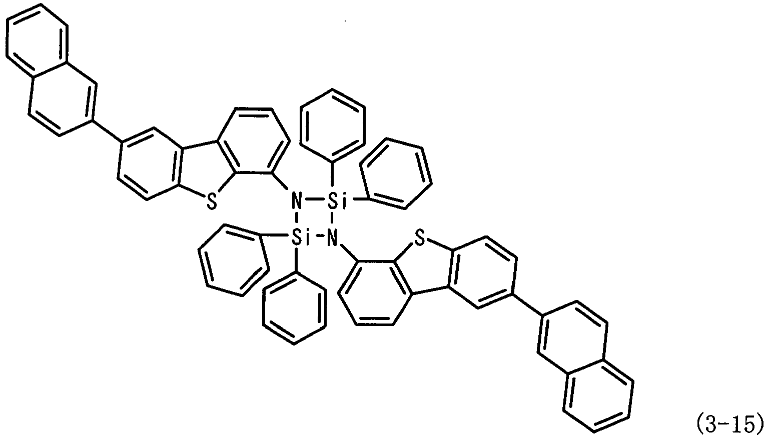

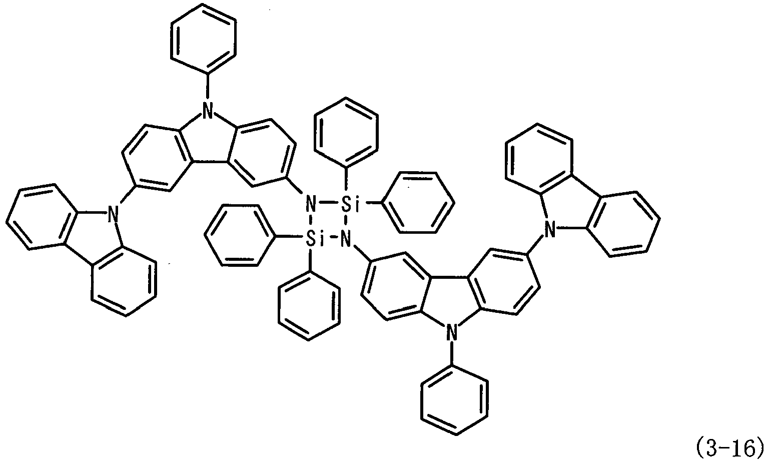

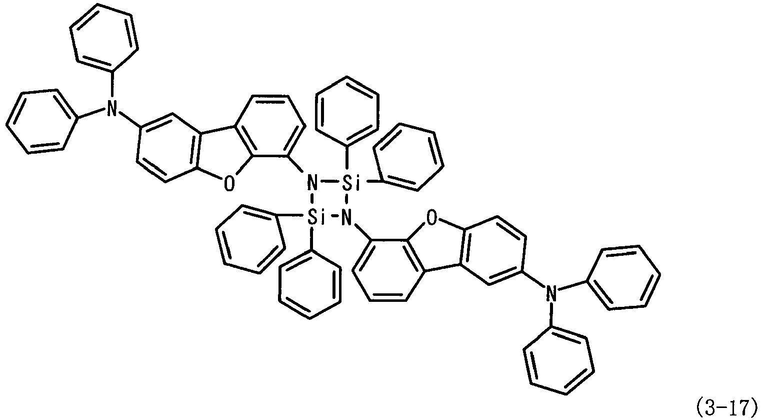

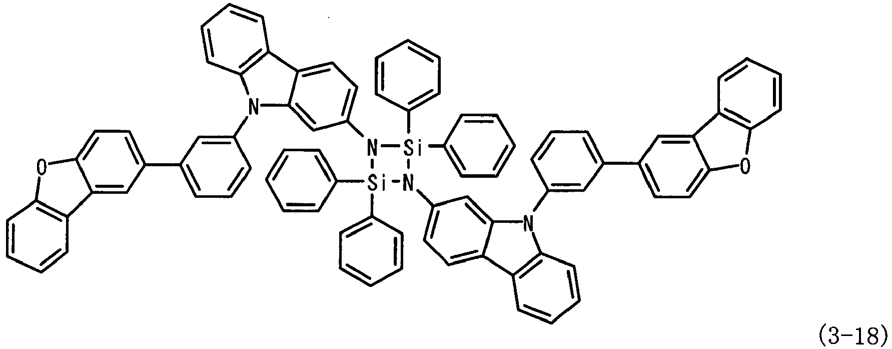

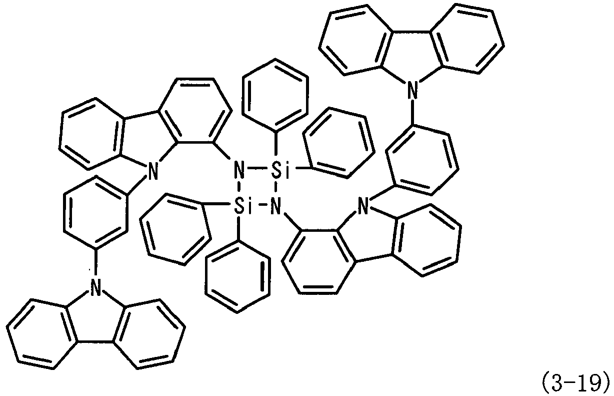

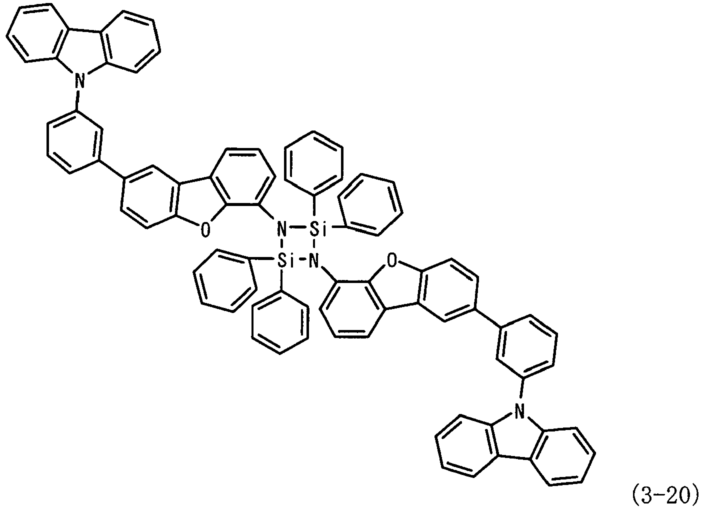

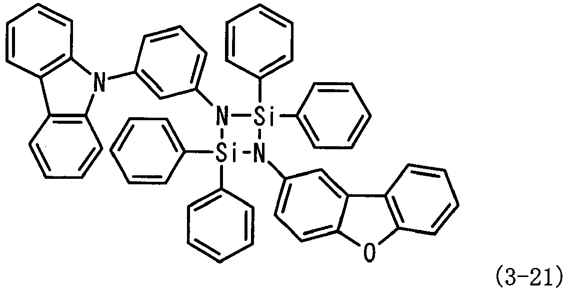

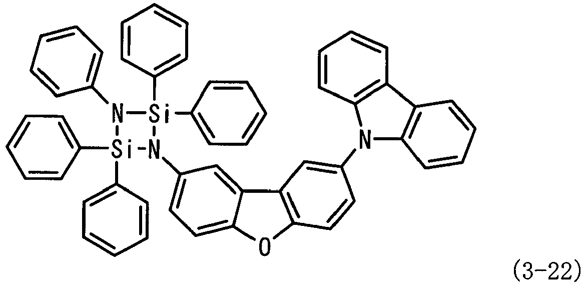

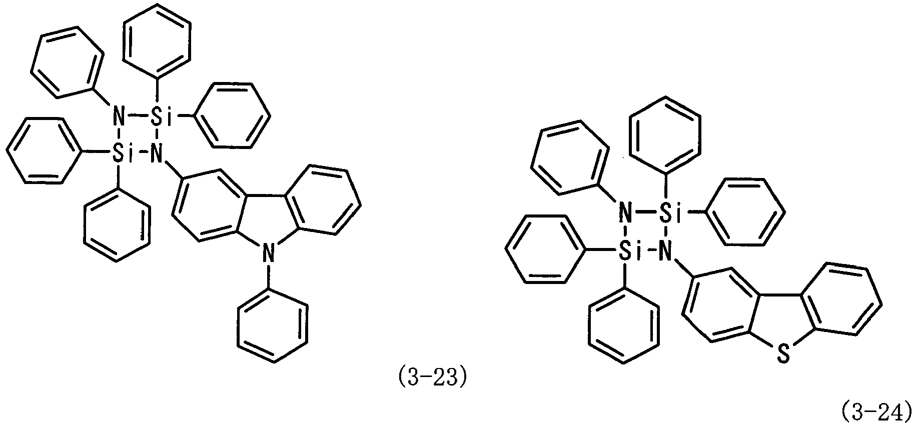

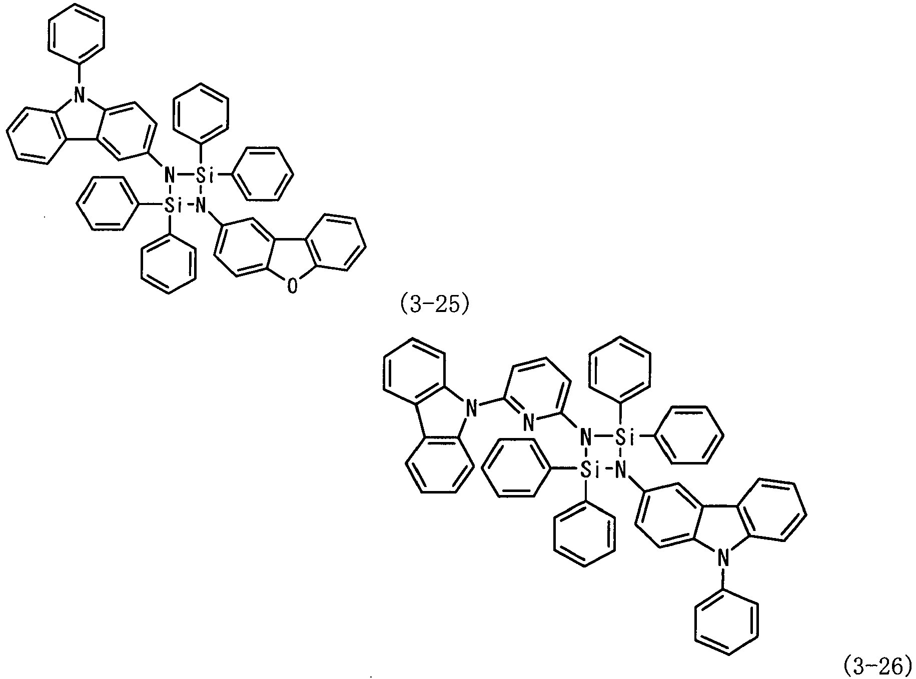

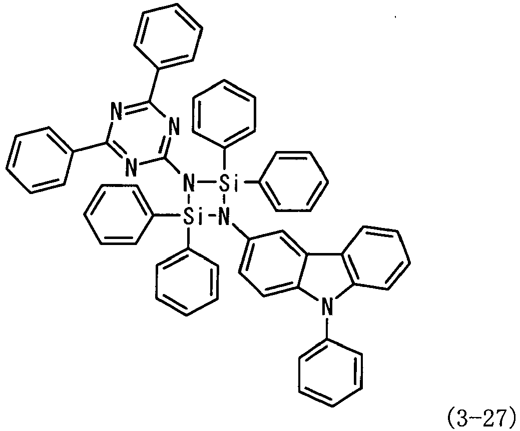

Next, the material for an organic EL device of the present invention and the organic EL device of the present invention are described. The material for an organic EL device of the present invention is formed of a silicon-containing four-membered ring compound represented by the general formula (1). The material for an organic EL device of the present invention may be used alone or as a mixture with any other material for an organic EL device, and for example, may be used as a mixture with each of various dopants. Examples of the dopant that may be used include: coumarin-, quinacridone-, rubrene-, and stilbene-based derivatives; fluorescent dyes; and noble metal complexes such as an iridium complex and a platinum complex.

The organic EL device of the present invention is an organic EL device using the material for an organic EL device of the present invention. Specifically, the organic EL device of the present invention includes at least one organic layer and at least one layer of the organic layer contains the silicon-containing four-membered ring compound.

The organic EL device of the present invention is an organic electronic device formed of an organic EL device obtained by laminating, on a substrate, an anode, an organic layer including a light-emitting layer, and a cathode, in which at least one layer of the organic layer contains the material for an organic EL device of the present invention.

The structure of the organic EL device of the present invention is described with reference to the drawings. However, the structure of the organic EL device of the present invention is by no means limited to one illustrated in the drawings.

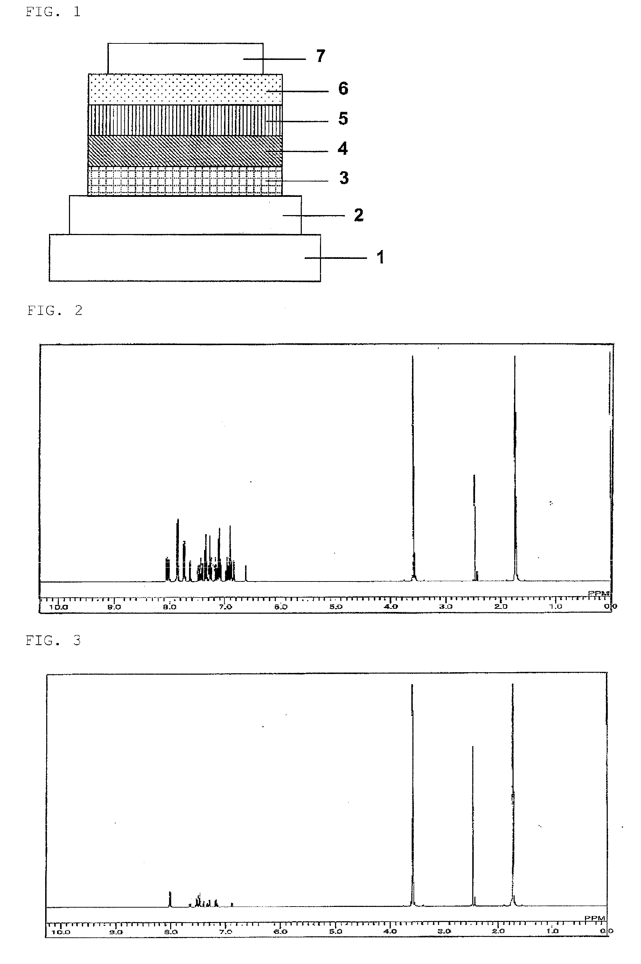

FIG. 1 is a sectional view illustrating a structural example of a general organic EL device used in the present invention. Reference numerals 1, 2, 3, 4, 5, 6, and 7 represent a substrate, an anode, a hole-injecting layer, a hole-transporting layer, a light-emitting layer, an electron-transporting layer, and a cathode, respectively. The organic EL device of the present invention may include an exciton-blocking layer adjacent to the light-emitting layer, or may include an electron-blocking layer between the light-emitting layer and the hole-injecting layer. The exciton-blocking layer may be inserted on any of the anode side and the cathode side of the light-emitting layer, and may also be inserted simultaneously on both sides. The organic EL device of the present invention includes the substrate, the anode, the light-emitting layer, and the cathode as its essential layers. The organic EL device of the present invention preferably includes a hole-injecting/transporting layer and an electron-injecting/transporting layer in addition to the essential layers, and more preferably includes a hole-blocking layer between the light-emitting layer and the electron-injecting/transporting layer. It should be noted that the hole-injecting/transporting layer means any one or both of the hole-injecting layer and the hole-transporting layer, and that the electron-injecting/transporting layer means any one or both of an electron-injecting layer and the electron-transporting layer.

It should be noted that it is possible to adopt a reverse structure compared with FIG. 1, that is, a structure formed by laminating the layers on the substrate 1 in the order of the cathode 7, the electron-transporting layer 6, the light-emitting layer 5, the hole-transporting layer 4, and the anode 2. In this case as well, a layer may be added or eliminated as required.

The material for an organic EL device of the present invention may be used for any of the layers in the organic EL device. The material is preferably used for the light-emitting layer, the hole-transporting layer, the electron-blocking layer, the hole-blocking layer, or the electron-transporting layer, and is particularly preferably used for the light-emitting layer, the electron-transporting layer, or the hole-blocking layer.

### -Substrate-

The organic EL device of the present invention is preferably supported by a substrate. The substrate is not particularly limited, and any substrate that has long been conventionally used for an organic EL device may be used. For example, a substrate made of glass, a transparent plastic, quartz, or the like may be used.

### -Anode-

Preferably used as the anode in the organic EL device is an anode formed by using, as an electrode substance, any of a metal, an alloy, an electrically conductive compound, and a mixture thereof, all of which have a large work function (4 eV or more). Specific examples of such electrode substance include metals such as Au and conductive transparent materials suchas CuI, indium tin oxide (ITO), SnO₂, and ZnO. Further, it may be possible to use a material such as IDIXO (In₂O₃-ZnO), which may be used for manufacturing an amorphous, transparent conductive film. In order to produce the anode, it may be possible to form any of those electrode substances into a thin film by using a method such as vapor deposition or sputtering and form a pattern having a desired design thereon by photolithography. Alternatively, in the case of not requiring high pattern accuracy (about 100 µm or more), a pattern may be formed via a mask having a desired shape when any of the above-mentioned electrode substances is subj ected to vapor deposition or sputtering. Alternatively, when a coatable substance such as an organic conductive compound is used, it is also possible to use a wet film-forming method such as a printing method or a coating method. When luminescence is taken out from the anode, the transmittance of the anode is desirably controlled to more than 10%. Further, the sheet resistance as the anode is preferably several hundred Ω/□ or less. Further, the thickness of the resultant film is, depending on the material used, selected from usually the range of 10 to 1,000 nm, preferably the range of 10 to 200 nm.

### -cathode-

On the other hand, used as the cathode is a cathode formed by using, as an electrode substance, any of a metal (referred to as electron-injecting metal), an alloy, an electrically conductive compound, and a mixture thereof, all of which have a small work function (4 eV or less). Specific examples of such electrode substance include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, and a rare earth metal. Of those, for example, a mixture of an electron-injecting metal and a second metal as a stable metal having a larger work function value than the former metal, such as a magnesium/silver mixture, a magnesium/aluminum mixture, a magnesium/indiummixture, an aluminum/aluminum oxide (Al₂O₃) mixture, or a lithium/aluminum mixture, or aluminum is suitable from the viewpoints of electron-injecting property and durability against oxidation or the like. The cathode may be produced by forming any of those electrode substances into a thin film by using a method such as vapor deposition or sputtering. Further, the sheet resistance as the cathode is preferably several hundred Ω/□ or less, and the thickness of the resultant film is selected from usually the range of 10 nm to 5 µm, preferably the range of 50 to 200 nm. It should be noted that, in order for luminescence produced to pass through, any one of the anode and cathode of the organic EL device is preferably transparent or semi-transparent, because the light emission luminance improves.

Further, after any of the above-mentioned metals is formed into a film having a thickness of 1 to 20 nm as a cathode, any of the conductive transparent materials mentioned in the description of the anode is formed into a film on the cathode, thereby being able to produce a transparent or semi-transparent cathode. Then, by applying this, it is possible to produce a device in which both the anode and cathode have transparency.

### -Light-emitting layer-

The light-emitting layer, which may be any one of a fluorescent light-emitting layer and a phosphorescent light-emitting layer, is preferably the phosphorescent light-emitting layer.

When the light-emitting layer is the fluorescent light-emitting layer, at least one kind of fluorescent light-emitting material may be used alone as a fluorescent light-emitting material, but it is preferred that the fluorescent light-emitting material be used as a fluorescent light-emitting dopant and a host material be incorporated.

Although the material for an organic EL device of the present invention can be used as the fluorescent light-emitting material in the light-emitting layer, when the material is used in any other organic layer, any other fluorescent light-emitting material can be used. The other fluorescent light-emitting material can also be selected from ones known by many patent literatures and the like. Examples thereof include: a benzoxazole derivative, a benzimidazole derivative, a benzothiazole derivative, a styrylbenzene derivative, a polyphenyl derivative, a diphenylbutadiene derivative, a tetraphenylbutadiene derivative, a naphthalimide derivative, a coumarin derivative, a fused aromatic compound, a perinone derivative, an oxadiazole derivative, an oxazine derivative, analdazine derivative, a pyrrolidine derivative, a cyclopentadiene derivative, a bisstyrylanthracene derivative, a quinacridone derivative, a pyrrolopyridine derivative, a thiadiazolopyridine derivative, a cyclopentadiene derivative, a styrylamine derivative, a diketopyrrolapyrrole derivative, and an aromatic dimethylidyne compound; various metal complexes exemplified by a metal complex of an 8-quinolinol derivative and a metal complex, rare earthmetal complex, or transition metal complex of a pyrromethene derivative; polymer compounds such as polythiophene, polyphenylene, and polyphenylenevinylene; and an organic silane derivative. Preferred examples thereof include a fused aromatic compound, a styryl compound, a diketopyrrolopyrrole compound, an oxazine compound, and a metal complex, transition metal complex, or lanthanoid complex of pyrromethene. More preferred examples thereof include naphthacene, pyrene, chrysene, triphenylene, benzo [c] phenanthrene, benzo [a] anthracene, pentacene, perylene, fluoranthene, acenaphthofluoranthene, dibenzo[a,j]anthracene, dibenzo[a,h]anthracene, benzo[a]naphthacene, hexacene, anthanthrene, naphtho[2,1-f]isoquinoline, α-naphthophenanthridine, phenanthroxazole, quinolino[6,5-f]quinoline, and benzothiophanthrene. Each of those materials may have an aryl group, a heteroaromatic ring group, a diarylamino group, or an alkyl group as a substituent.

When the fluorescent light-emitting material is used as the fluorescent light-emitting dopant and the host material is incorporated, the amount of the fluorescent light-emitting dopant to be incorporated into the light-emitting layer desirably falls within the range of 0.01 to 20 wt%, preferably 0.1 to 10 wt%.

In ordinary cases, the organic EL device is caused to emit light by producing a light-emitting substance in an excited state through the injection of charge into a light-emitting substance from each of both electrodes, i.e., the anode and the cathode. It is said that in the case of a charge inj ection-type organic EL device, 25% of produced excitons are excited to excited singlet states and the remaining 75% are excited to excited triplet states. A specific fluorescent light-emitting substance is known to express thermally activated delayed fluorescence via the following mechanism. After the transition of its energy into an excited triplet state through intersystem crossing or the like, the substance undergoes inverse intersystem crossing into an excited singlet state by virtue of triplet-triplet annihilation or the absorption of a thermal energy, thereby radiating fluorescence. The organic EL device using the compound of the present invention can also express delayed fluorescence. In this case, the fluorescence can include both fluorescent emission and delayed fluorescent emission. It should be noted that light emission from the host material may constitute part of the light emission.

In the case where the light-emitting layer is a phosphorescent light-emitting layer, a phosphorescent light-emitting dopant and a host material are incorporated. It is recommended to use, as a material for the phosphorescent light-emitting dopant, a material containing an organic metal complex including at least one metal selected from ruthenium, rhodium, palladium, silver, rhenium, osmium, iridium, platinum, and gold. Specific examples thereof include, but not limited to, the compounds disclosed in the following patent publications and the like. The numbers of the patent publications are shown below.

For example, WO 2009/073245 A1, WO 2009/046266 A1, WO 2007/095118 A3, WO 2008/156879 A1, WO 2008/140657 A1, US 2008/261076 A, JP 2008-542203 A, WO 2008/054584 A1, JP 2008-505925 A, JP 2007-522126 A, JP 2004-506305 A, JP 2006-513278 A, JP 2006-50596 A, WO 2006/046980 A1, WO 2005/113704 A3, US 2005/260449 A, US 2005/2260448 A, US 2005/214576 A, WO 2005/076380 A3, US 2005/119485 A, WO 2004/045001 A3, WO 2004/045000 A3, WO 2006/100888 A1, WO 2007/004380 A1, WO 2007/023659 A1, WO 2008/035664 A1, JP 2003-272861 A, JP 2004-111193 A, JP 2004-319438 A, JP 2007-2080 A, JP 2007-9009 A, JP 2007-227948 A, JP 2008-91906 A, JP 2008-311607 A, JP 2009-19121 A, JP 2009-46601A, JP 2009-114369 A, JP 2003-253128 A, JP2003-253129 A, JP 2003-253145 A, JP 2005-38847 A, JP 2005-82598 A, JP 2005-139185 A, JP 2005-187473 A, JP 2005-220136 A, JP 2006-63080 A, JP 2006-104201 A, JP2006-111623A, JP 2006-213720 A, JP 2006-290891 A, JP 2006-298899 A, JP 2006-298900 A, WO 2007/018067 A1, WO 2007/058080 A1, WO 2007/058104 A1, JP 2006-131561 A, JP 2008-239565 A, JP 2008-266163 A, JP 2009-57367 A, JP 2002-117978 A, JP 2003-123982 A, JP 2003-133074 A, JP 2006-93542 A, JP 2006-131524 A, JP 2006-261623 A, JP 2006-303383 A, JP 2006-303394 A, JP 2006-310479 A, JP 2007-88105 A, JP 2007-258550 A, JP 2007-324309 A, JP 2008-270737 A, JP 2009-96800 A, JP 2009-161524 A, WO 2008/050733 A1, JP 2003-73387 A, JP 2004-59433 A, JP 2004-155709 A, JP 2006-104132 A, JP 2008-37848 A, JP 2008-133212 A, JP 2009-57304 A, JP 2009-286716 A, JP 2010-83852 A, JP 2009-532546 A, JP 2009-536681 A, and JP 2009-542026 A.

Preferred examples of the phosphorescent light-emitting dopant include complexes such as Ir(ppy)3, complexes such as Ir(Bt)2·acac3, and complexes such as PtOEt3, the complexes each having a noble metal element such as Ir as a central metal. Specific examples of those complexes are shown below, but the complexes are not limited to the compounds described below.

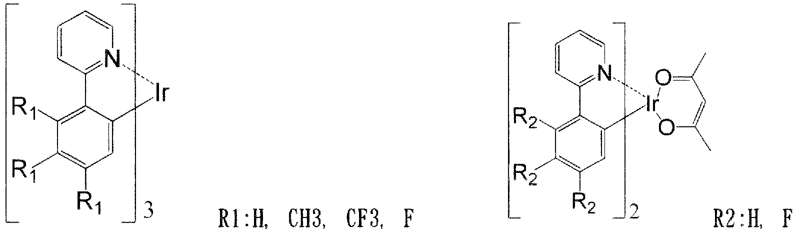

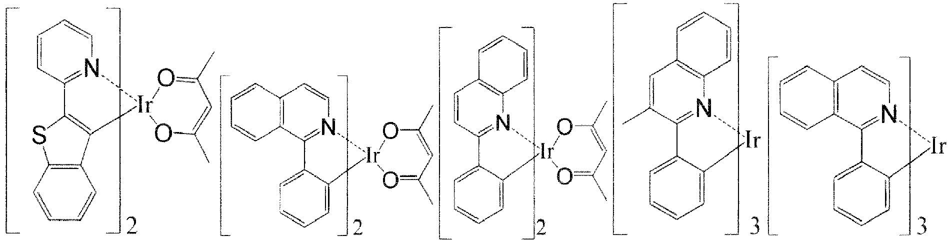

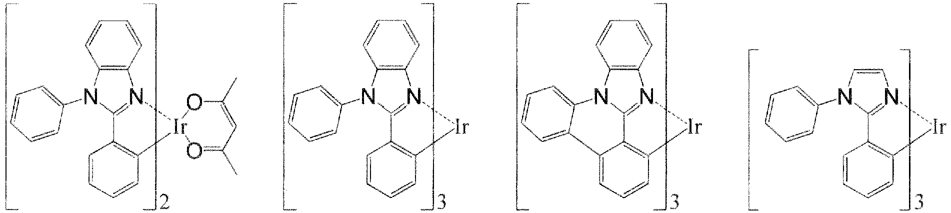

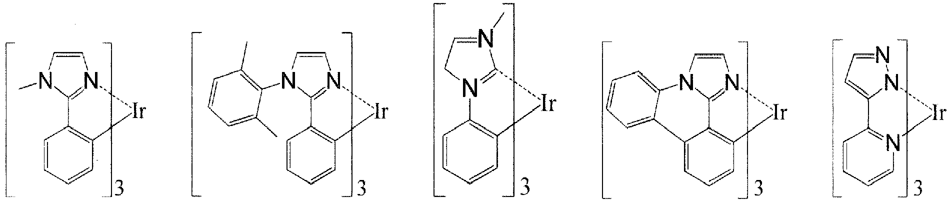

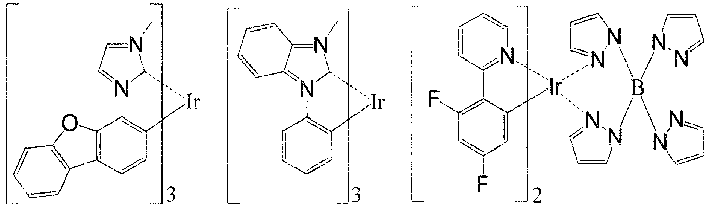

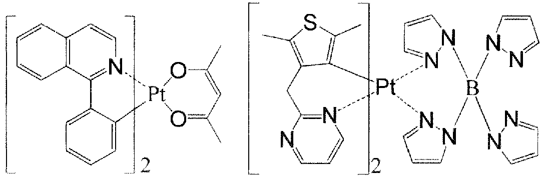

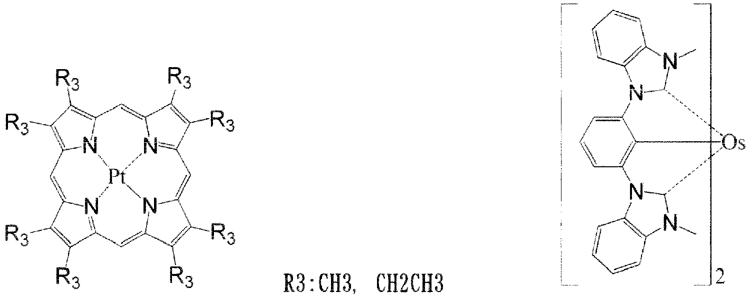

It is preferred that the content of the phosphorescent light-emitting dopant in the light-emitting layer fall within the range of 0.1 to 50 wt%, more preferably 1 to 30 wt%.

It is preferred to use, as a host material in the light-emitting layer, the material for an organic EL device of the present invention. However, when the material is used in any of the organic layers other than the light-emitting layer, the material to be used in the light-emitting layer may be any other host material other than the compound of the present invention, and the material for an organic EL device of the present invention and any other host material may be used in combination. Further, a plurality of kinds of known host materials may be used in combination.

It is preferred to use, as a usable known host compound, a compound that has a hole-transporting ability or an electron-transporting ability, is capable of preventing luminescence from having a longer wavelength, and has a high glass transition temperature.

Such other host materials are known because they are mentioned in many patent literatures and the like, and hence may be chosen from those in the patent literatures and the like. Specific examples of the host material include, but not particularly limited to, an indole derivative, a carbazole derivative, anindolocarbazole derivative, a triazole derivative, an oxazole derivative, an oxadiazole derivative, an imidazole derivative, a polyarylalkane derivative, a pyrazoline derivative, a pyrazolone derivative, a phenylenediamine derivative, an arylamine derivative, an amino-substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidene-based compound, a porphyrin-based compound, an anthraquinodimethane derivative, an anthrone derivative, a diphenylquinone derivative, a thiopyran dioxide derivative, a heterocyclic tetracarboxylic acid anhydride such as naphthalene perylene, a phthalocyanine derivative, various metal complexes typified by a metal complex of an 8-quinolinol derivative, a metal phthalocyanine, and metal complexes of benzoxazole and benzothiazole derivatives, and polymer compounds such as a polysilane-based compound, a poly(N-vinylcarbazole) derivative, an aniline-based copolymer, a thiophene oligomer, a polythiophene derivative, a polyphenylene derivative, a polyphenylenevinylene derivative, and a polyfluorene derivative.

### -Injecting layer-

The injecting layer refers to a layer formed between an electrode and an organic layer for the purpose of lowering a driving voltage and improving a light emission luminance, and includes a hole-injecting layer and an electron-injecting layer. The injecting layer may be interposed between the anode and the light-emitting layer or the hole-transporting layer, or may be interposed between the cathode and the light-emitting layer or the electron-transporting layer. The injecting layer may be formed as required. Although the material for an organic EL device of the present invention can be used as an injecting material, when the material is used in any other organic layer, any compound selected from conventionally known compounds can be used.

### -Hole-blocking layer-

The hole-blocking layer has, in a broad sense, the function of an electron-transporting layer, and is formed of a hole-blocking material that has a remarkably small ability to transport holes while having a function of transporting electrons, and hence the hole-blocking layer is capable of improving the probability of recombining an electron and a hole by blocking holes while transporting electrons.

The material for an organic EL device is preferably used in the hole-blocking layer. However, when the material is used in any other organic layer, a known material for a hole-blocking layer may be used. In addition, it is possible to use, as a material for the hole-blocking layer, any of materials for the electron-transporting layer to be described later as required.

### -Electron-blocking layer-

The electron-blocking layer is formed of a material that has a remarkably small ability to transport electrons while having a function of transporting holes, and hence the electron-blocking layer is capable of improving the probability of recombining an electron and a hole by blocking electrons while transporting holes.

The material for an organic EL device of the present invention is preferably used as a material for the electron-blocking layer. However, when the material is used in any other organic layer, any of materials for the hole-transporting layer to be described later can be used as required. The thickness of the electron-blocking layer is preferably 3 to 100 nm, more preferably 5 to 30 nm.

### -Exciton-blocking layer-

The exciton-blocking layer refers to a layer used for blocking excitons produced by the recombination of a hole and an electron in the light-emitting layer from diffusing in charge-transporting layers. The insertion of this layer enables effective confinement of the excitons in the light-emitting layer, thereby being able to improve the luminous efficiency of the device. The exciton-blocking layer may be inserted on any of the anode side and the cathode side of the adjacent light-emitting layer, and may also be inserted simultaneously on both sides.

Although the material for an organic EL device of the present invention can be used as a material for the exciton-blocking layer, when the material is used in any other organic layer, any compound selected from conventionally known compounds can be used. Examples thereof include 1,3-dicarbazolylbenzene (mCP) and bis(2-methyl-8-quinolinolato)-4-phenylphenolatoaluminum(III) (BAlq).

### -Hole-transporting layer-

The hole-transporting layer is formed of a hole-transporting material having a function of transporting holes, and a single hole-transporting layer or a plurality of hole-transporting layers may be formed.

The hole-transporting material has any one of hole-injecting property, hole-transporting property, and electron-blocking property, and any of an organic compound and an inorganic compound may be used. It is preferred to use the material for an organic EL device of the present invention in the hole-transporting layer. However, when the material is used in any other organic layer, any compound selected from conventionally known compounds may be used. Examples of the known hole-transporting material that may be used include a porphyrin compound, an aromatic tertiary amine compound, a styrylamine compound, a triazole derivative, an oxadiazole derivative, an imidazole derivative, a polyarylalkane derivative, a pyrazoline derivative and a pyrazolone derivative, an amino-substituted chalcone derivative, an oxazole derivative, a styrylanthracene derivative, a fluorenone derivative, a hydrazone derivative, a stilbene derivative, a silazane derivative, an aniline-based copolymer, and a conductive high-molecular weight oligomer, in particular, a thiophene oligomer. However, a porphyrin compound, an aromatic tertiary amine compound, or a styrylamine compound is preferably used, and an aromatic tertiary amine compound is more preferably used.

### -Electron-transporting layer-

The electron-transporting layer is formed of a material having a function of transporting electrons, and a single electron-transporting layer or a plurality of electron-transporting layers may be formed.

An electron-transporting material (which also serves as a hole-blocking material in some cases) has only to have a function of transferring electrons injected from the cathode into the light-emitting layer. The material for an organic EL device of the present invention is preferably used in the electron-transporting layer. However, when the material is used in any other organic layer, any compound selected from conventionally known compounds may be used. Examples thereof include a nitro-substituted fluorene derivative, a diphenylquinone derivative, a thiopyran dioxide derivative, a carbodiimide, a fluorenylidenemethane derivative, anthraquinodimethane and an anthrone derivative, and an oxadiazole derivative. Further, it is also possible to use, as the electron-transporting material, a thiadiazole derivative prepared by substituting an oxygen atom on an oxadiazole ring with a sulfur atom in the oxadiazole derivative and a quinoxaline derivative that has a quinoxaline ring known as an electron withdrawing group. Further, it is also possible to use a polymer material in which any of those materials is introduced in a polymer chain or is used as a polymer main chain.

### Examples

Hereinafter, the present invention is described in more detail by way of Examples. It should be appreciated that the present invention is not limited to Examples below and may be carried out in various forms as long as the various forms do not deviate from the gist of the present invention.

The routes described below were used to synthesize a chalcogen-containing aromatic compound used in the present invention. It should be noted that the number of each compound corresponds to the number given to the exemplified compound.

### Example 1

### Synthesis of compound (1-4)

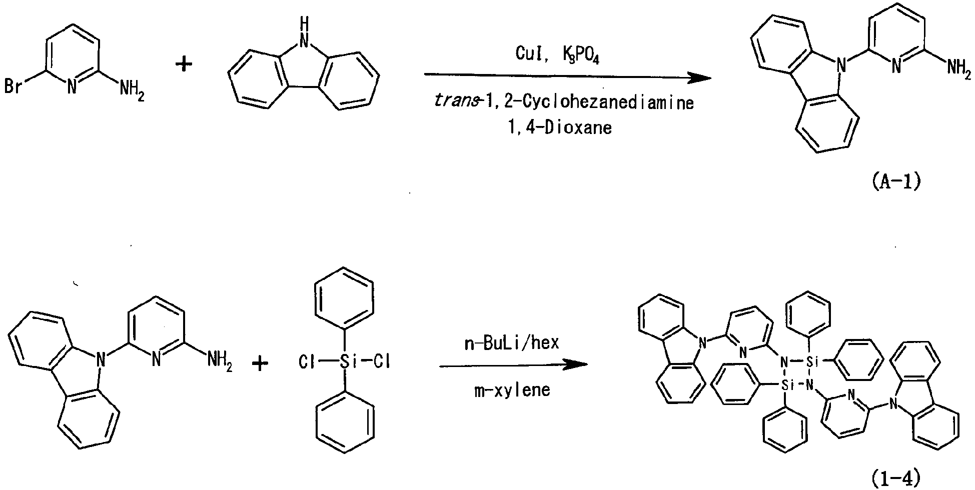

Under a nitrogen atmosphere, 20.0 g (0.12 mol) of 2-amino-6-bromopyridine, 38.7 g (0.23 mol) of carbazole, 4.4 g (0.0023 mol) of copper iodide, 190.5 g (0.92 mol) of tripotassium phosphate, and 1,000 ml of 1,4-dioxane were loaded and stirred. 21.0 g (0.184 mol) of trans-1,2-cyclohexanediamine were added to the mixture, and then the whole was stirred at 120°C for 6 hr. Next, the reaction solution was cooled to room temperature and then the inorganic salt was separated by filtration. After that, the solvent was distilled off under reduced pressure. The resultant residue was purified by column chromatography to provide 16.0 g (0.062 mol, 51% yield) of an intermediate A-1.

Under a nitrogen atmosphere, 14.0 g (0.054 mol) of the intermediate A-1 and 140 ml of m-xylene were loaded and stirred. The mixture was cooled to 0 °C and then 75.6 ml (0.12 mol) of 1.57 M n-BuLi/hex were dropped to the mixture. After that, 13.7 g (0. 054 mol) of dichlorodiphenylsilane were dropped to the resultant, and then the mixture was stirred at 140°C for 4 days. The reaction solution was cooled to room temperature. While the solution was stirred, 100 ml of distilled water and 800 ml of dichloromethane were added to the solution, and then 100 ml of a 2 N aqueous solution of hydrochloric acid were added thereto. The organic layer was washed with distilled water (2×100 ml) and then the resultant organic layer was dried with anhydrous magnesium sulfate. After that, magnesium sulfate was separated by filtration and then the solvent was distilled off under reduced pressure. The resultant residue was purified by column chromatography to provide 2.2 g (0.003 mol, 9% yield) of a compound (1-4) as a white powder.

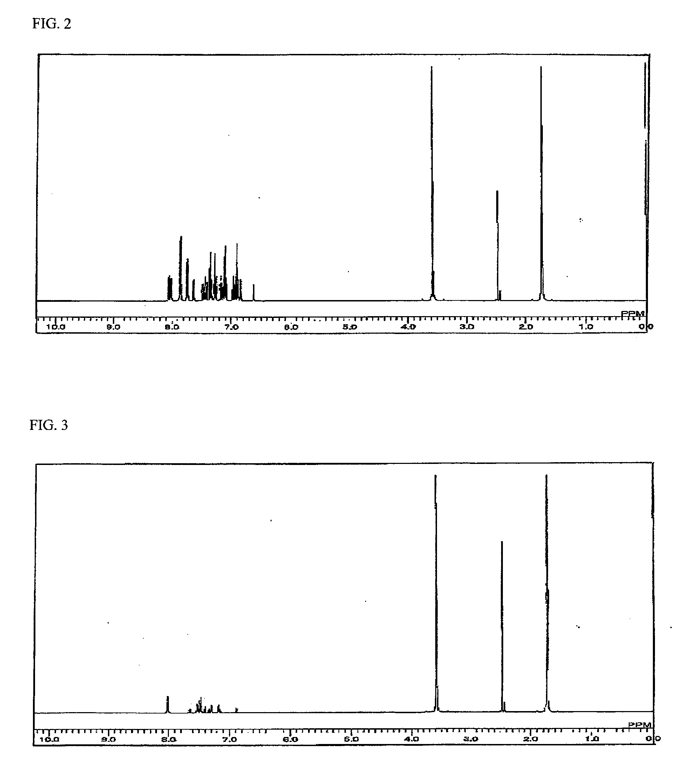

The APCI-TOFMS of the compound showed an [M+H]⁺ peak at an m/z of 879. FIG. 2 shows the results of its ¹H-NMR measurement (measurement solvent: THF-d8).

### Example 2

### Synthesis of compound (3-3)

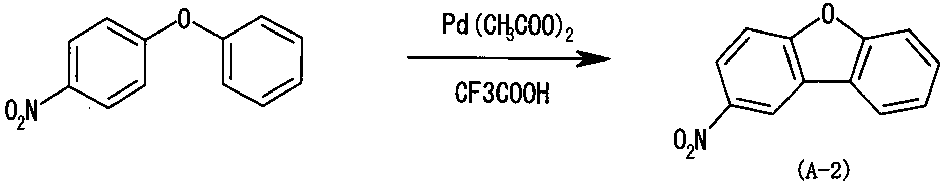

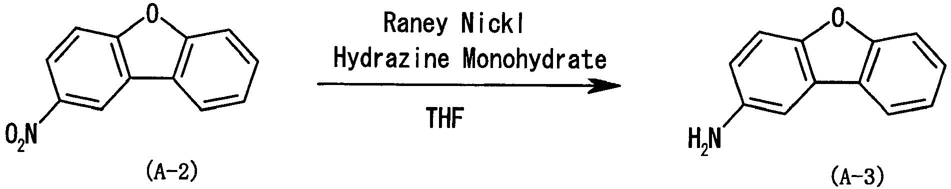

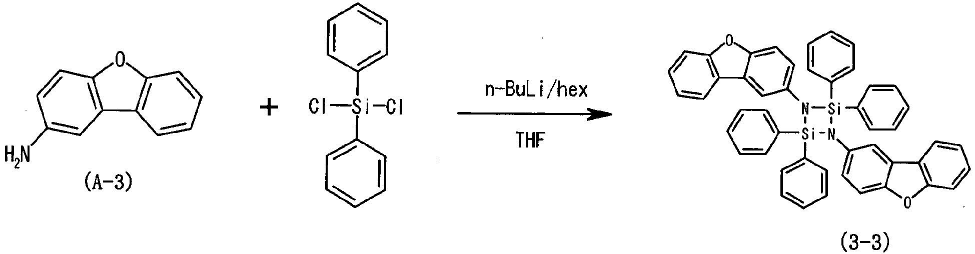

Under a nitrogen atmosphere, 50 g (0.23 mol) of 4-nitrodiphenyl ether, 62.5 g (0.28 mol) of palladium acetate, and 1,000 ml of trifluoroacetic acid were loaded, and then the mixture was stirred at 70°C for 4 hr. The reaction solution was cooled to room temperature, and then 500 ml of distilled water and 500 ml of dichloromethane were added to the solution while the solution wasstirred. The organic layer was washed with distilled water (2×100 ml) and then the resultant organic layer was dried with anhydrous magnesium sulfate. After that, magnesium sulfate was separated by filtration and then the solvent was distilled off under reduced pressure. The resultant residue was purified by column chromatography to provide 26.2 g (0.12 mol, 53% yield) of an intermediate A-2.

Under a nitrogen atmosphere, 25 g (0.12 mol) of the intermediate A-2, 6.25 g of Raney nickel, 50 g (0.16 mol) of hydrazine monohydrate, and 150 ml of THF were loaded, and the mixture was stirred at 80 °C. 50 g (0.16 mol) of hydrazine monohydrate were added to the mixture, and then the whole was stirred at 80°C for 13 hr. The reaction solution was cooled to room temperature and then the inorganic salt was separated by filtration. After that, the solvent was distilled off under reduced pressure. The resultant residue was purified by column chromatography to provide 14.3 g (0.078 mol, 65% yield) of an intermediate A-3.

Under a nitrogen atmosphere, 11.5 g (0.063 mol) of the intermediate A-3 and 120 ml of THF were loaded and stirred. The mixture was cooled to 0°C and then 85 ml (0.14 mol) of 1.63 Mn-BuLi/hex were dropped to the mixture. After that, 15.9 g (0.063 mol) of dichlorodiphenylsilane were dropped to the resultant, and then the mixture was stirred at 80°C for 3 days. The reaction solution was cooled to room temperature, and then 100 ml of a 2 N aqueous solution of hydrochloric acid were added to the solution while the solution was stirred. The solvent was distilled off under reduced pressure and then the resultant solid was separated by filtration. The resultant residue was purified by column chromatography to provide 4.1 g (0.006 mol, 18% yield) of a compound (3-3) as white powder.

The APCI-TOFMS of the compound showed an [M+H]⁺ peak at an m/z of 727. FIG. 3 shows the results of its ¹H-NMR measurement (measurement solvent: THF-d8).

### Example 3

### Synthesis of compound (1-25)

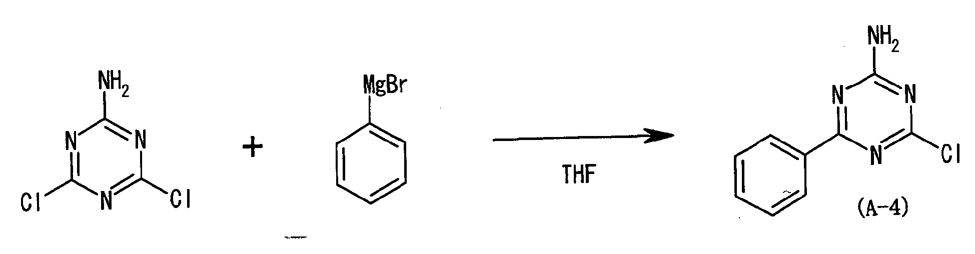

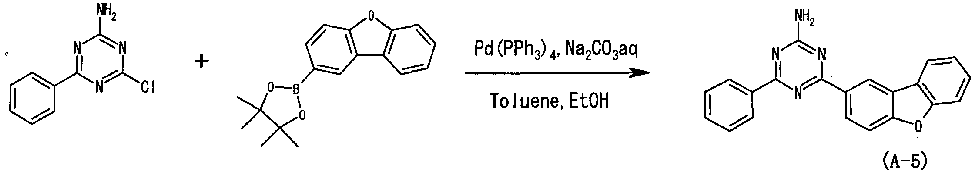

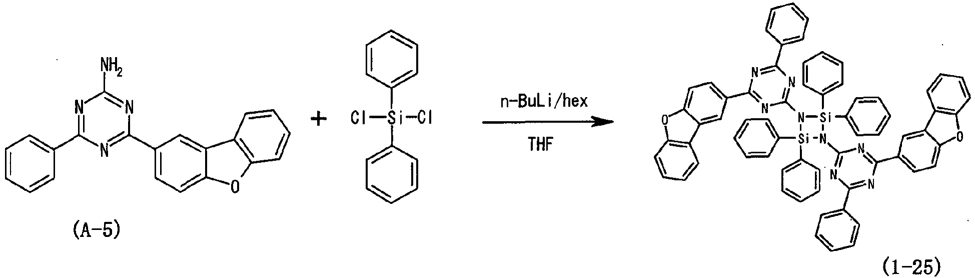

Under a nitrogen atmosphere, 17.5 g (0.11 mol) of 1,3-dichloro-5-aminotriazine and 300 ml of THF were loaded, and then the mixture was stirred at 0°C. 100 ml g (0.11 mol) of a 1.06 M solution of phenyl magnesium bromide in THF were slowly dropped to the mixture and then the whole was stirred for 2 hr without being treated. After that, 200 ml of toluene and 300 ml of a 2 N aqueous solution of hydrochloric acid were added to the resultant while the resultant was stirred. The organic layer was washed with distilled water (2×100 ml) and then the resultant organic layer was dried with anhydrous magnesium sulfate. After that, magnesium sulfate was separated by filtration and then the solvent was distilled off under reduced pressure. The resultant residue was purified by column chromatography to provide 11.9 g (0.058 mol, 52% yield) of an intermediate A-4.

Under a nitrogen atmosphere, 10.0 g (0.048 mol) of the intermediate A-4, 14.1 g (0.048 mol) of 2-pinacolatoborondibenzofuran, 5.5 g (0.0048 mol) of tetrakis(triphenylphosphine)palladium[0], 400 ml of toluene, and 100 ml of ethanol were loaded and stirred. An aqueous solution of sodium carbonate obtained by dissolving 20.35 g (0.192 mol) of sodium carbonate in 400 ml of water was added to the mixture, and then the whole was stirred at 100°C for 5 hr. The reaction solution was cooled to room temperature. The organic layer was washed with distilled water (2×100 ml) and then the resultant organic layer was dried with anhydrous magnesium sulfate. After that, magnesium sulfate was separated by filtration and then the solvent was distilled off under reduced pressure. The resultant residue was purified by column chromatography to provide 12.3 g (0.036 mol, 76% yield) of an intermediate A-5.

Under a nitrogen atmosphere, 11.5 g (0.034 ml) of the intermediate A-5 and 100 ml of THF were loaded and stirred. The mixture was cooled to 0°C and then 46 ml (0.075 mol) of 1.63 M n-BuLi/hex were dropped to the mixture. After that, 8.6 g (0.034 mol) of dichlorodiphenylsilane were dropped to the resultant, and then the mixture was stirred at 80°C for 3 days. The reaction solution was cooled to room temperature. While the solution was stirred, 100 ml of a 2 N aqueous solution of hydrochloric acid were added thereto. The solvent was distilled off under reduced pressure and then the resultant solid was separated by filtration. The resultant residue was purified by column chromatography to provide 4.2 g (0.004 mol, 17% yield) of a compound (1-25) as white powder.

The APCI-TOFMS of the compound showed an [M+H]⁺ peak at an m/z of 1037.

### Example 4

### Synthesis of compound (2-15)

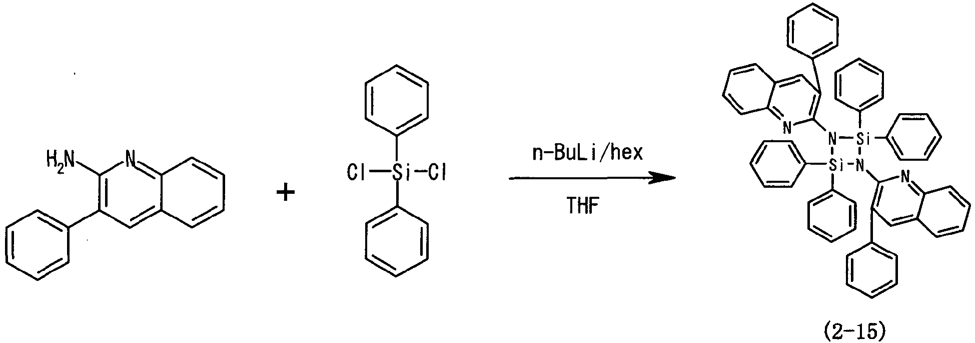

Under a nitrogen atmosphere, 15.0 g (0.068 mol) of 2-amino-3-phenylguinoline and 120 ml of THF were loaded and stirred. The mixture was cooled to 0°C and then 92 ml (0.15 mol) of 1.63 M n-BuLi/hex were dropped to the mixture. After that, 17.2 g (0.068 mol) of dichlorodiphenylsilane were dropped to the resultant, and then the mixture was stirred at 80°C for 3 days. The reaction solution was cooled to room temperature. While the solution was stirred, 100 ml of a 2 N aqueous solution of hydrochloric acid were added thereto. The solvent was distilled off under reduced pressure and then the resultant solid was separated by filtration. The resultant residue was purified by column chromatography to provide 3.8 g (0.005 mol, 14% yield) of a compound (2-15) as white powder.

The APCI-TOFMS of the compound showed an [M+H]⁺ peak at an m/z of 801.

### Example 5

### Synthesis of compound (1-19)

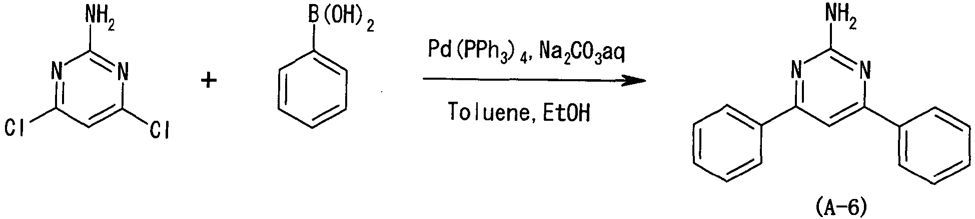

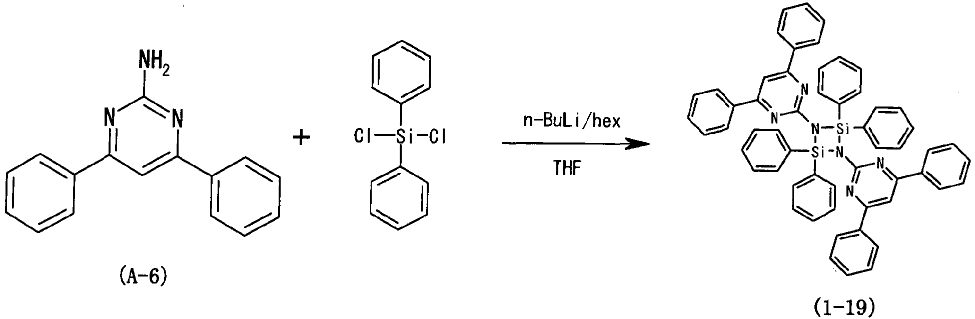

Under a nitrogen atmosphere, 20.0 g (0.12 mol) of 2-amino-4,6-dichloropyrimidine, 24.7 g (0.27 mol) of phenylboronic acid, 3.1 g (0.0027 mol) of tetrakis(triphenylphosphine)palladium[0], 400 ml of toluene, and 100 ml of ethanol were loaded and stirred. An aqueous solution of sodium carbonate obtained by dissolving 85.9 g (0.81 mol) of sodium carbonate in 400 ml of water was added to the mixture, and then the whole was stirred at 100°C for 3 hr. The reaction solution was cooled to room temperature. The organic layer was washed with distilled water (2×100 ml) and then the resultant organic layer was dried with anhydrous magnesium sulfate. After that, magnesium sulfate was separated by filtration and then the solvent was distilled off under reduced pressure. The resultant residue was purified by column chromatography to provide 22.3 g (0.09 mol, 75% yield) of an intermediate A-6.

Under a nitrogen atmosphere, 15.2 g (0.06 mol) of the intermediate A-6 and 100 ml of THF were loaded and stirred. The mixture was cooled to 0°C and then 92 ml (0.15 mol) of 1.63 Mn-BuLi/hex were dropped to the mixture. After that, 8.6 g (0.034 mol) of dichlorodiphenylsilane were dropped to the resultant, and then the mixture was stirred at 80°C for 3 days. The reaction solution was cooled to room temperature. While the solution was stirred, 100 ml of a 2 N aqueous solution of hydrochloric acid were added thereto. The solvent was distilled off under reduced pressure and then the resultant solid was separated by filtration. The resultant residue was purified by column chromatography to provide 3.2 g (0.004 mol, 13% yield) of a compound (1-19) as white powder.

The APCI-TOFMS of the compound showed an [M+H]⁺ peak at an m/z of 855.

### Example 6

### Synthesis of compound (3-11)

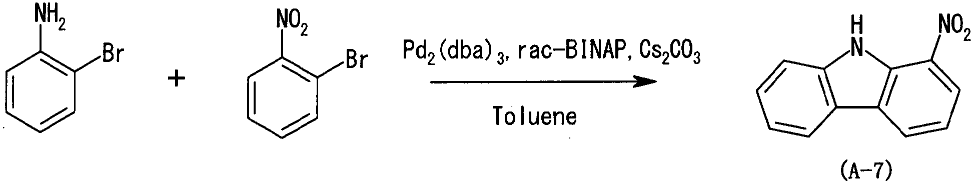

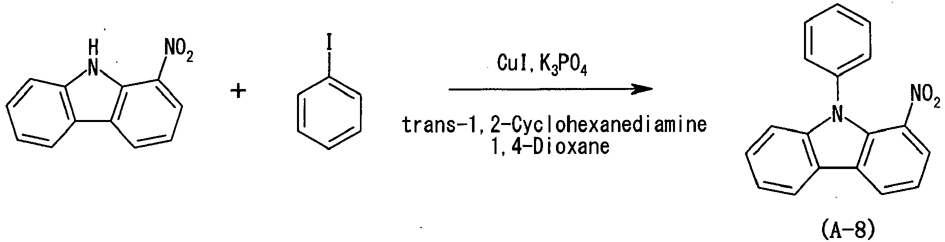

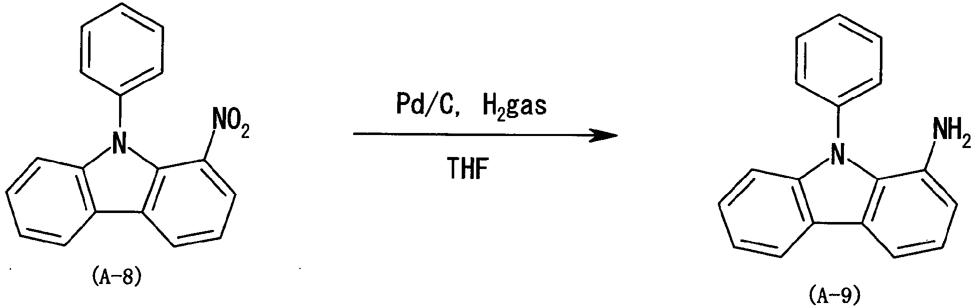

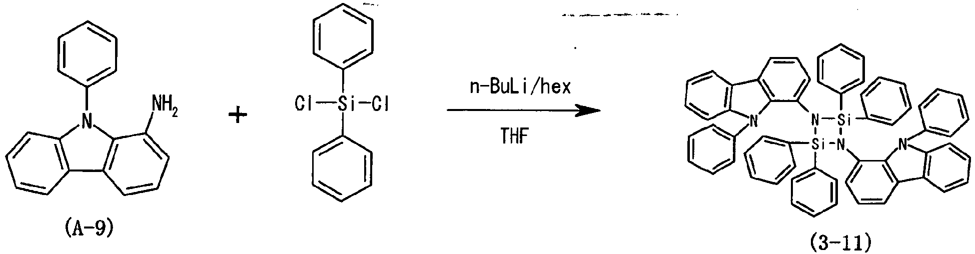

Under a nitrogen atmosphere, 21.3 g (0.124 mol) of 2-bromoaniline, 25.0 g (0.124 mol) of 2-bromonitrobenzene, 5.6 g (0.0062 mol) of tris(dibenzylideneacetone)dipalladium, 8.5 g (0.0093 mol) of (±)-2,2'-bis(diphenylphosphino)-1,1'-binaphthyl, and 80.8 g (0.248 mol) of cesium carbonate, and 500 ml of toluene were loaded, and the mixture was stirred at 110°C for 24 hr. The solvent was distilled off under reduced pressure and then the resultant residue was purified by column chromatography to provide 20. 0 g (0.094 mol, 76% yield) of an intermediate A-7 as white powder.

Under a nitrogen atmosphere, 15.0 g (0.071 mol) of the intermediate A-7, 15.9 g (0.078 mol) of iodobenzene, 1.5 g (0.008 mol) of copper iodide, 66.2 g (0.31 mol) of tripotassium phosphate, and 500 ml of 1,4-dioxane were loaded and stirred. 8.9 g (0.078 mol) of trans-1,2-cyclohexanediamine were added to the mixture, and then the whole was stirred at 120°C for 8 hr. The reaction solution was cooled to room temperature and then the inorganic salt was separated by filtration. After that, the solvent was distilled off under reduced pressure. The resultant residue was purified by column chromatography to provide 17.2 g (0.06 mol, 84% yield) of an intermediate A-8.

Under a nitrogen atmosphere, 15.0 g (0.052 mol) of the intermediate A-8 and 200 ml of THF were loaded, and then the mixture was stirred at room temperature. 3 g of a 10% palladium-carbon catalyst were added to the mixture and then the inside of a container was deaerated with a diaphragm pump. The container was filled with a hydrogen gas and then the mixture was stirred for 72 hr. After the palladium-carbon catalyst had been filtered, the solvent was distilled off under reduced pressure. Thus, 11.3 g (0.044 mol, 84% yield) of an intermediate A-9 were obtained.

Under a nitrogen atmosphere, 10.4 g (0.04 mol) of the intermediate A-9 and 100 ml of THF were loaded and stirred. The mixture was cooled to 0°C and then 54 ml (0.088 mol) of 1 . 63 M n-BuLi /hex were dropped to the mixture. After that, 10.1 g (0.04 mol) of dichlorodiphenylsilane were dropped to the resultant, and then the mixture was stirred at 80°C for 5 days. The reaction solution was cooled to room temperature, and then 100 ml of a 2 N aqueous solution of hydrochloric acid were added to the solution while the solution was stirred. The solvent was distilled off under reduced pressure and then the resultant solid was separated by filtration. The resultant residue was purified by column chromatography to provide 1.9 g (0.002 mol, 10% yield) of a compound (3-11) as white powder.

The APCI-TOFMS of the compound showed an [M+H]⁺ peak at an m/z of 877.

### Example 7

### Synthesis of compound (1-8)

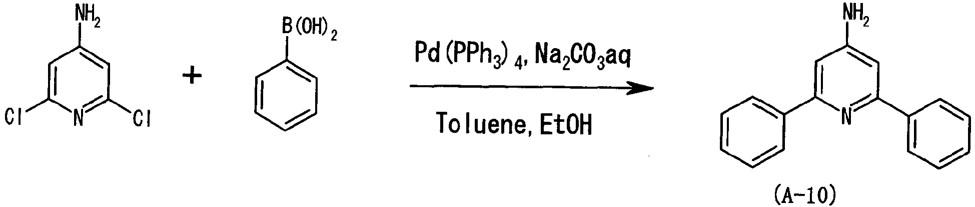

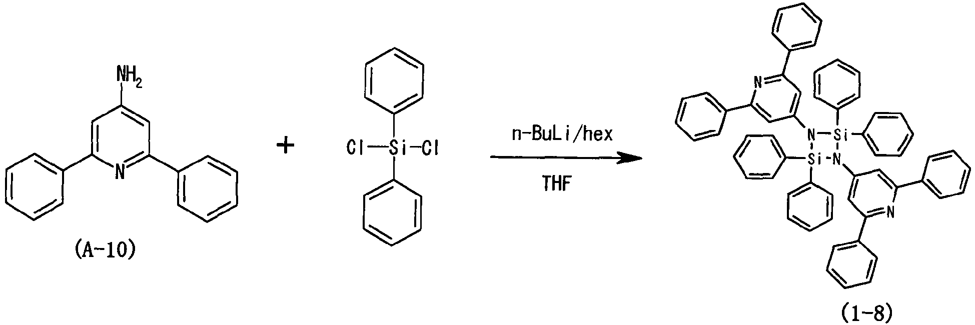

Under a nitrogen atmosphere, 20.0 g (0.12 mol) of 4-amino-2,6-dichloropyridine, 24.9 g (0.27 mol) of phenylboronic acid, 3.1 g (0.0027 mol) of tetrakis(triphenylphosphine)palladium[0], 400 ml of toluene, and 100 ml of ethanol were loaded and stirred. An aqueous solution of sodium carbonate obtained by dissolving 85. 9 g (0.81 mol) of sodium carbonate in 400 ml of water was added to the mixture, and then the whole was stirred at 100°C for 5 hr. The reaction solution was cooled to room temperature. The organic layer was washed with distilled water (2×100 ml) and then the resultant organic layer was dried with anhydrous magnesium sulfate. After that, magnesium sulfate was separated by filtration and then the solvent was distilled off under reduced pressure. The resultant residue was purified by column chromatography to provide 26.3 g (0.11 mol, 89% yield) of an intermediate A-10.

Under a nitrogen atmosphere, 14.7 g (0.06 mol) of the intermediate A-10 and 100 ml of THF were loaded and stirred. The mixture was cooled to 0°C and then 92 ml (0.15 mol) of 1. 63 M n-BuLi/hex were dropped to the mixture. After that, 8.6 g (0.034 mol) of dichlorodiphenylsilane were dropped to the resultant, and then the mixture was stirred at 80°C for 4 days. The reaction solution was cooled to room temperature, and then 100 ml of a 2 N aqueous solution of hydrochloric acid were added to the solution while the solution was stirred. The solvent was distilled off under reduced pressure and then the resultant solid was separated by filtration. The resultant residue was purified by column chromatography to provide 2.1 g (0.002 mol, 8% yield) of a compound (1-8) as white powder.

The APCI-TOFMS of the compound showed an [M+H]⁺ peak at an m/z of 853.

### Example 8

### Synthesis of compound (2-19)

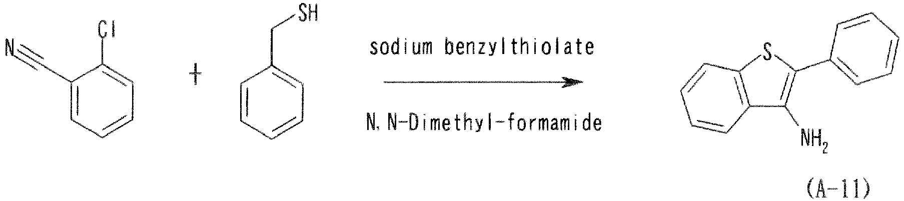

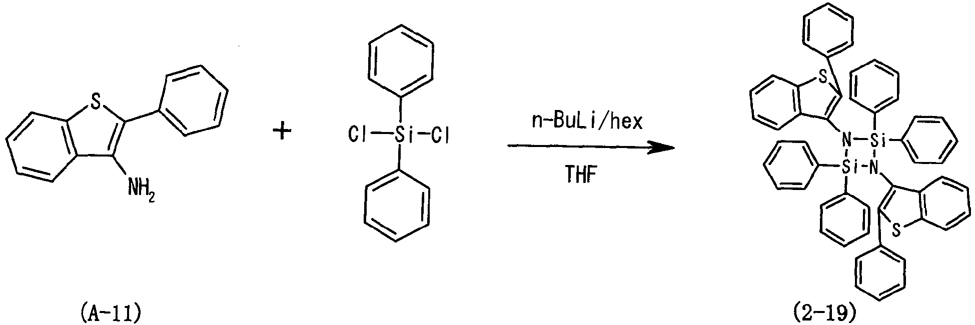

Under a nitrogen atmosphere, 3.4 g (0.084 mol) of sodium hydride and 150 ml of DMF were loaded, and then the mixture was stirred at 0°C. A solution obtained by dissolving 9.7 g (0.078 mol) of benzylmercaptan in 100 ml of DMF was slowly dropped to the mixture and then the whole was stirred at 0 °C for 1 hr. After that, 10.5 g (0.084 mol) of sodium benzylthiolate were added to the resultant. Next, a solution obtained by dissolving 11.6 g (0.084 mol) of 2-chlorobenzonitrile in 100 ml of DMF was dropped to the mixture, and then the whole was stirred at room temperature for 3 hr. After that, 200 ml of distilled water and 200 ml of dichloromethane were added to the resultant. The organic layer was washed with distilled water (2×100 ml) and then the resultant organic layer was dried with anhydrous magnesium sulfate. After that, magnesium sulfate was separated by filtration and then the solvent was distilled off under reduced pressure. The resultant residue was purified by column chromatography to provide 13.5 g (0.06 mol, 71% yield) of an intermediate A-11.

Under a nitrogen atmosphere, 9.2 g (0.041 mol) of the intermediate A-11 and 100 ml of THF were loaded and stirred. The mixture was cooled to 0°C and then 55 ml (0.09 mol) of 1 . 63 M n-BuLi/hex were dropped to the mixture. After that, 10.4 g (0.041 mol) of dichlorodiphenylsilane were dropped to the resultant, and then the mixture was stirred at 80°C for 3 days. The reaction solution was cooled to room temperature, and then 100 ml of a 2 N aqueous solution of hydrochloric acid were added to the solution while the solution was stirred. The solvent was distilled off under reduced pressure and then the resultant solid was separated by filtration. The resultant residue was purified by column chromatography to provide 2.0 g (0.002 mol, 12% yield) of a compound (2-19) as white powder.

The APCI-TOFMS of the compound showed an [M+H]⁺ peak at an m/z of 811.

### Example 9

Each thin film was laminated by a vacuum deposition method at a degree of vacuum of 4.0×10⁻⁵ Pa on a glass substrate on which an anode formed of ITO having a thickness of 110 nm had been formed. First, copper phthalocyanine (CuPC) was formed on ITO so as to have a thickness of 25 nm. Next, 4,4'-bis[N-(1-naphthyl)-N-phenylamino]biphenyl (NPB) was formed thereon so as to serve as a hole-transporting layer having a thickness of 40 nm. Next, the compound (1-4) as a host material and tris(2-phenylpyridine)iridium(III) (Ir(ppy)₃) as a phosphorescent light-emitting dopant were co-deposited from different deposition sources onto the hole-transporting layer to form a light-emitting layer having a thickness of 40 nm. The concentration of Ir(ppy)₃ in the light-emitting layer was 10.0 wt%. Next, tris(8-hydroxyquinolinato)aluminum(III) (Alq3) was formed thereon so as to serve as an electron-transporting layer having a thickness of 20 nm. Further, lithium fluoride (LiF) was formed on the electron-transporting layer so as to serve as an electron-injecting layer having a thickness of 1.0 nm. Finally, aluminum (Al) was formed on the electron-injecting layer so as to serve as an electrode having a thickness of 70 nm. Thus, an organic EL device was produced.

An external power source was connected to the resultant organic EL device to apply a DC voltage to the device. As a result, it was confirmed that the device had such light-emitting characteristics as shown in Table 1. The columns "luminance", "voltage", and "luminous efficiency" in Table 1 show values at 10 mA/cm². It should be noted that it was found that the local maximum wavelength of the emission spectrum of the device was 530 nm and hence light emission from Ir(ppy)₃ was obtained.

### Examples 10 to 16

Organic EL devices were each produced in the same manner as in Example 9 except that the compound (3-3), (1-25), (2-15), (1-19), (3-11), (1-8), or (2-19) was used instead of the compound (1-4) as the host material for the light-emitting layer in Example 9. It was found that the local maximum wavelength of the emission spectrum of each of the devices was 530 nm and hence light emission from Ir(ppy)₃ was obtained. Table 1 shows the respective light-emitting characteristics.

### Example H1 (comparison)

An organic EL device was produced in the same manner as in Example 9 except that CBP was used as the host material for the light-emitting layer in Example 9. It was identified that the local maximum wavelength of the emission spectrum of the device was 535 nm and hence light emission from Ir(ppy)₃ was obtained. Table 1 shows light-emitting characteristics.

**[Table 1]**

| Example | Host material compound | Luminance (cd/m²) | Voltage (V) | Visual luminous efficiency (1m/W) |
|---|---|---|---|---|
| 9 | 1-4 | 2950 | 8.3 | 11.2 |
| 10 | 3-3 | 3020 | 8.4 | 11.3 |
| 11 | 1-25 | 3220 | 8.0 | 12.6 |
| 12 | 2-15 | 2780 | 8.1 | 10.8 |
| 13 | 1-19 | 3140 | 8.1 | 12. 2 |
| 14 | 3-11 | 2940 | 8.7 | 10.6 |
| 15 | 1-8 | 3100 | 8.2 | 12. 2 |
| 16 | 2-19 | 2650 | 8.6 | 9.7 |
| H1 | CBP | 2420 | 9.3 | 8.2 |

### Industrial Applicability

A balance among various energy values for the ionization potential, electron affinity, and triplet excitation energy of the silicon-containing four-membered ring compound to be used in the organic electroluminescent device of the present invention may be improved by introducing an aromatic heterocyclic group to its skeleton. In addition, the compound may be allowed to have a high charge-resisting characteristic and a good charge balance by separating its HOMO and LUMO as molecular orbitals responsible for hole- and electron-transferring abilities.

## Claims

1. A material for an organic electroluminescent device, comprising a silicon-containing four-membered ring compound represented by the general formula (1): 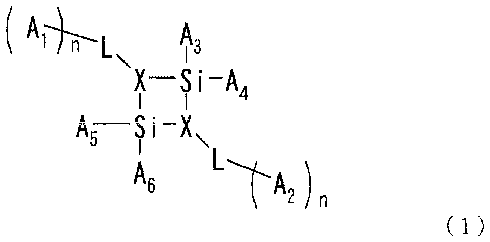 in the formula (1):
X's each independently represent nitrogen or phosphorus;
L's each independently represent an (n+1)-valent aromatic hydrocarbon group having 6 to 24 carbon atoms or an (n+1)-valent aromatic heterocyclic group having 3 to 19 carbon atoms, and at least one of the L' s represents an aromatic heterocyclic group having 3 to 19 carbon atoms;
A₁ to A₆ each independently represent an alkyl group having 1 to 30 carbon atoms, a cycloalkyl group having 3 to 30 carbon atoms, an alkenyl group having 2 to 30 carbon atoms, an alkynyl group having 2 to 30 carbon atoms, an aromatic hydrocarbon group having 6 to 50 carbon atoms, an aromatic heterocyclic group having 3 to 50 carbon atoms, or an amino group having 2 to 30 carbon atoms; and
n's each independently represent an integer of 0 to 3.

2. A material for an organic electroluminescent device according to claim 1, wherein the two X's in the general formula (1) each represent nitrogen or each represent phosphorus.

3. A material for an organic electroluminescent device according to claim 1, wherein the two X's in the general formula (1) each represent nitrogen.

4. A material for an organic electroluminescent device according to claim 3, wherein the two L's in the general formula (1) each represent an (n+1)-valent aromatic heterocyclic group having 3 to 19 carbon atoms.

5. A material for an organic electroluminescent device according to claim 4, wherein the two L's in the general formula (1) represent the same aromatic heterocyclic group.

6. An organic electroluminescent device, comprising:
a substrate;
an anode;
an organic layer; and
a cathode,
the anode, the organic layer, and the cathode being laminated on the substrate,
wherein the organic layer contains the material for an organic electroluminescent device according to any one of claims 1 to 5.

7. An organic electroluminescent device according to claim 6, wherein the organic layer containing the material for an organic electroluminescent device comprises at least one layer selected from the group consisting of a light-emitting layer, an electron-transporting layer, a hole-transporting layer, an electron-blocking layer, and a hole-blocking layer.

8. An organic electroluminescent device according to claim 6, wherein the organic layer containing the material for an organic electroluminescent device comprises a light-emitting layer containing a phosphorescent light-emitting dopant.
